# EUROPÄISCHE PATENTSCHRIFT

(11) **EP 3 472 876 B1**
(45) Veröffentlichungstag und Bekanntmachung des Hinweises auf die Patenterteilung: **17.04.2024**
(21) Anmeldenummer: 17730164.5
(22) Anmeldetag: 14.06.2017
(51) Int. Cl.: H10K 85/30, C09K 11/06, H10K 50/155

(54) **VERNETZENDE P-DOTANDEN ZUR P-DOTIERUNG ORGANISCHER LOCHLEITER**
CROSS-LINKING P-DOPANT FOR P-DOPING ORGANIC HOLE CONDUCTORS
DOPANTS P DE RÉTICULATION POUR LE DOPAGE P DE CONDUCTEURS DE TROUS ORGANIQUES

(30) Priorität: 16.06.2016 DE 102016111062
(43) Veröffentlichungstag der Anmeldung: 24.04.2019
(73) Patentinhaber: Merck Patent GmbH, 64293 Darmstadt (DE)
(72) Erfinder: SCHMID, Günter, 91334 Hemhofen (DE); KESSLER, Florian, 96193 Wachenroth (DE); STEGMAIER, Katja, 64287 Darmstadt (DE); ECKES, Fabrice, 68300 Saint Louis (FR); HEIL, Holger, 60316 Frankfurt am Main (DE); BURKHART, Beate, 64293 Darmstadt (DE); SEIM, Henning, 64289 Darmstadt (DE)
(74) Vertreter: Merck Patent Association
(86) Internationale Anmeldenummer: PCT/EP2017/064636
(87) Internationale Veröffentlichungsnummer: WO 2017/216271

(56) Entgegenhaltungen:
- EP-A1- 2 772 956
- WO-A1-2013/156125
- WO-A1-2015/018539
- WO-A1-2016/030330
- WO-A2-2013/182389
- DE-A1-102014 210 412
- US-A1- 2012 238 774
- US-A1- 2016 122 605
- US-B2- 7 897 962

## Beschreibung

Die vorliegende Erfindung betrifft ein Verfahren zur Herstellung vernetzter, lochleitender elektrischer Schichten, eine vernetzte, lochleitende elektrische Schicht und ein organisch elektronisches Bauelement umfassend eine vernetzte, lochleitende elektrische Schicht.

Diese Patentanmeldung beansprucht die Priorität der deutschen Patentanmeldung 10 2016 111 062.0 Die kommerziell wichtigsten Bauelemente der organischen Elektronik werden heutzutage im Wesentlichen mittels zweier unterschiedlicher Herstellverfahren erhalten. Eingesetzt werden dabei zum einen Nassprozesse, in welcher organische Schichten durch Abscheiden aus einer Lösung über verschiedene Drucktechniken, wie zum Beispiel Tintenstrahl-, Tief-, Offsetdruck, Spin- oder Slotcoating aufgebaut werden. Zum anderen kann die Abscheidung der Schichten aus der Gasphase heraus mittels Sublimation, also thermischer Verdampfung im Vakuum, erfolgen. Durch Sublimation werden die bisher effizientesten, kommerziell verfügbaren organischen Bauelemente, wie beispielsweise organische lichtemittierende Dioden, Solarzellen, Transistoren und bipolare Transistoren hergestellt. Die Effizienz dieser Bauteile wird unter anderem auch dadurch erreicht, dass diese aus sehr vielen einzelnen Schichten aufgebaut sind, wobei jede der Schichten eine spezielle, auch auf den Ort im Bauteil bezogene, elektrische Funktion besitzt.

Organische Bauelemente, welche durch Lösemittelprozesse hergestellt werden, besitzen zurzeit noch eine deutlich geringere Komplexität im Aufbau. Dies ergibt sich prozessbedingt aufgrund der Anforderung, dass eine abgeschiedene organische Schicht in weiteren Verarbeitungsschritten nicht durch die folgenden organischen Lösungsmittel angelöst werden darf. Um dieser Randbedingung gerecht zu werden, ist es am sichersten, wenn im weiteren Prozess mit orthogonalen (das heißt nicht mit dem vorherigen Solvent mischbaren) Lösungsmitteln gearbeitet wird, damit darunterliegende Schichten nicht wieder angelöst werden. Diese Verfahrensweise limitiert die Anzahl einsetzbarer Lösemittel und die Anzahl verarbeitbarer organischer Substanzen und beschränkt somit die Möglichkeit einer elektrischen Feinanpassung nassprozesszierbarer Schichtfolgen.

Während oben angegebene Randbedingungen für die Herstellung jedweder elektrisch funktionaler, das heißt blockierender, n- oder p-leitender, emittierender, organischer Schicht in organischen Bauelementen gilt, ist insbesondere die Herstellung hocheffizienter und langlebiger p-leitender, also lochleitender, Schichten herausfordernd. Dies in Anbetracht der einzuhaltenden Prozessbedingungen und Auswahl geeigneter Verbindungen, welche eben jene hohe Funktionalität bei gleichzeitig langen Standzeiten der daraus aufgebauten Bauelemente zeigen müssen.

Das p-Dotieren mittels organischer Metallkomplexe, sowohl durch Vakuum- als auch Nassprozesse, wird beispielsweise in der DE 102012209523 beschrieben. Das Problem der Auswaschung oder Segregation der Dotanden bleibt aber in dieser Anmeldung ungelöst.

Die Druckschrift WO 2016/030330 A1 betrifft ein organisches Licht emittierendes Bauelement und ein Verfahren zur Herstellung eines organischen Licht emittierenden Bauelements.

In der Druckschrift DE 10 2014 210 412 A1 wird eine p-dotierende Vernetzung organischer Lochleiter beschrieben.

In der Druckschrift US 2016/122605 A1 wird eine vernetzbare Zusammensetzung, die ein Polyrotaxan und eine Verbindung mit mindestens zwei Oxiran- und/oder Oxetangruppen enthält, beschrieben.

Es ist daher die Aufgabe der vorliegenden Erfindung, ein Verfahren aufzuzeigen, welches durch Einsatz funktionalisierter p-Dotanden und optional funktionalisierter Lochleiter die Leitfähigkeit lochleitender elektrischer Schichten erhöht und gleichzeitig eine vernetzte, stabile Schicht erzeugt, welche gegenüber Auswaschungen, Segregation oder Eintrag schichtfremder Substanzen geschützt ist.

Gelöst wird diese Aufgabe durch die Merkmale des Anspruchs 1. Besondere Ausführungsformen der Erfindung werden in den Unteransprüchen wiedergegeben.

Die vorliegende Erfindung betrifft gemäß Anspruch 1 ein Verfahren zur Herstellung vernetzter, lochleitender elektrischer Schichten. Dabei werden funktionalisierte p-Dotanden umgesetzt. Die funktionalisierten p-Dotanden können durch eine chemische Reaktion untereinander vernetzen und/oder mit funktionalisierten Lochleitern vernetzen. Unter Vernetzen ist dabei hier und im Folgenden die Ausbildung kovalenter Bindungen zwischen den funktionalisierten p-Dotanden untereinander und/oder zwischen den funktionalisierten p-Dotanden und den funktionalisierten Lochleitern zu verstehen.

Die funktionalisierten p-Dotanden sind organische Metallkomplexe. Die Metallkomplexe umfassen zumindest ein Metall als Zentralatom und organische Liganden. Das Zentralatom ist aus einem Metall der Gruppen 6-15 des Periodensystems ausgewählt. Mindestens ein organischer Ligand ist aus einer Gruppe ausgewählt, die Liganden der folgenden Formeln I-V umfasst: 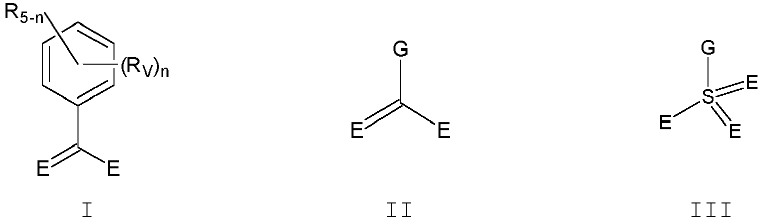 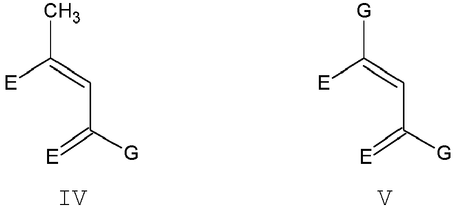 wobei
- E unabhängig voneinander Sauerstoff, Schwefel, Selen oder N(E₁)ₓ sind, wobei E₁ unabhängig voneinander ausgewählt ist aus der Gruppe umfassend H, D, substituiertes oder nicht substituiertes Alkyl oder Aryl und x = 0, 1 oder 2;
- R unabhängig voneinander H, D, F, C1-C20 verzweigtes und unverzweigtes, substituiertes oder nicht substituiertes Alkyl oder Aryl sind;
- R_{V} jeweils unabhängig voneinander ausgewählt sind aus der Gruppe umfassend substituiertes oder nicht substituiertes Aryl, Alkyl, Alkoxy, Cycloalkyl, Arylene, Halogenaryl, Heteroaryl, Heteroarylene, Heterocycloalkylene, Heterocycloalkyl, Halogenheteroaryl, Alkenyl, Halogenalkenyl, Alkinyl, Halogenalkinyl, Ketoaryl, Halogenketoaryl, Ketoheteroaryl, Ketoalkyl, Halogenketoalkyl, Ketoalkenyl, Halogenketoalkenyl und
- jedes R_{V} jeweils mindestens einen funktionalisierenden Rest ausgewählt aus der Gruppe R_{F} umfassend -OH, -COOH, -NH₂, - NHR', Halogen, C2-C40-Alkenyl, -Dienyl, -Alkinyl, - Alkenyloxy, -Dienyloxy, -Alkinyloxy, Acrylsäure, Oxetan, Oxiran, Silan, Acrylsäure, Anhydrid und Cyclobutan aufweist oder aus diesen Resten besteht; wobei R' = C1-C20 verzweigtes, unverzweigtes, substituiertes oder nicht substituiertes Alkyl oder Aryl ist;
- G = -C(R_{F})ᵤHᵥF_{w} mit u+v+w = 3;
- und n = 1 - 4.

Gemäß zumindest einer Ausführungsform sind R_{V} jeweils unabhängig voneinander ausgewählt aus der Gruppe umfassend substituiertes oder nicht substituierte C5-C20-Aryl, C1-C20-Alkyl, C1-C20-Alkoxy, C3-C20-Cycloalkyl, C5-C20-Halogenaryl, C5-C20-Heteroaryl, C3-C20-Heterocycloalkylene, C4-C20-Heterocycloalkyl, C5-C20-Halogenheteroaryl, C2-C20-Alkenyl, C2-C20-Halogenalkenyl, C2-C20-Alkinyl, C2-C20-Halogenalkinyl, Ketoaryl, Halogenketoaryl, Ketoheteroaryl, Ketoalkyl, Halogenketoalkyl, Ketoalkenyl, Halogenketoalkenyl und - jedes R_{V} jeweils mindestens einen funktionalisierenden Rest ausgewählt aus der Gruppe R_{F} umfassend -OH, -COOH, -NH₂, - NHR', Halogen, C2-C20-Alkenyl, C3-C20-Dienyl, C2-C20-Alkinyl, -Alkenyloxy, -Dienyloxy, -Alkinyloxy, Acrylsäure, Oxetan, Oxiran, Silan, Acrylsäure, Anhydrid und Cyclobutan aufweist oder aus diesen Resten besteht, wobei R' = C1-C20 verzweigtes, unverzweigtes, substituiertes oder nicht substituiertes Alkyl oder Aryl ist.

Gemäß zumindest einer Ausführungsform sind R_{V} jeweils unabhängig voneinander ausgewählt aus der Gruppe umfassend substituiertes oder nicht substituierte C5-C10-Aryl, C1-C10-Alkyl, C1-C10-Alkoxy, C3-C10-Cycloalkyl, C5-C10-Halogenaryl, C5-C10-Heteroaryl, C3-C10-Heterocycloalkylene, C5-C10-Heterocycloalkyl, C5-C10-Halogenheteroaryl, C2-C10-Alkenyl, C2-C10-Halogenalkenyl, C2-C10-Alkinyl, C2-C10-Halogenalkinyl, Ketoaryl, Halogenketoaryl, Ketoheteroaryl, Ketoalkyl, Halogenketoalkyl, Ketoalkenyl, Halogenketoalkenyl und
- jedes R_{V} jeweils mindestens einen funktionalisierenden Rest ausgewählt aus der Gruppe R_{F} umfassend -OH, -COOH, -NH₂, - NHR', Halogen, C2-C10-Alkenyl, C3-C10-Dienyl, C2-C10-Alkinyl, -Alkenyloxy, -Dienyloxy, -Alkinyloxy, Acrylsäure, Oxetan, Oxiran, Silan, Acrylsäure, Anhydrid und Cyclobutan aufweist oder aus diesen Resten besteht.

Bevorzugt sind R_{V} jeweils unabhängig voneinander ausgewählt aus der Gruppe umfassend substituiertes oder nicht substituiertes C5-C10-Aryl, C1-C10-Alkyl, C1-C10-Alkoxy, C3-C10-Cycloalkyl, C5-C10-Halogenaryl, C5-C10-Heteroaryl, C3-C10-Heterocycloalkylene, C5-C10-Heterocycloalkyl, C5-C10-Halogenheteroaryl, C2-C10-Alkenyl, C2-C10-Halogenalkenyl, C2-C10-Alkinyl, C2-C10-Halogenalkinyl, und
- jedes R_{V} jeweils mindestens einen funktionalisierenden Rest ausgewählt aus der Gruppe R_{F} umfassend -OH, -COOH, -NH₂, NHR', Halogen, C2-C10-Alkenyl, C3-C10-Dienyl, C2-C10-Alkinyl, -Alkenyloxy, -Dienyloxy, -Alkinyloxy, Acrylsäure, Oxetan, Oxiran, Silan, Acrylsäure, Anhydrid und Cyclobutan aufweist oder aus diesen Resten besteht.

Gemäß zumindest einer Ausführungsform werden die funktionalisierten p-Dotanden untereinander umgesetzt. Das bedeutet, dass die funktionalisierten p-Dotanden untereinander vernetzen und damit kovalente Bindungen zwischen den funktionalisierten p-Dotanden gebildet werden. Insbesondere werden die kovalenten Bindungen zwischen den Resten R_{V} oder R_{F} gebildet. Dabei können mindestens zwei funktionalisierte p-Dotanden untereinander vernetzen. Beispielsweise vernetzen 3 bis 10 oder 10 bis 100 funktionalisierte p-Dotanden untereinander, so dass mit anderen Worten das gebildete Netzwerk aus 3 bis 10 oder 10 bis 100 Monomereinheiten aufgebaut ist.

Gemäß zumindest einer Ausführungsform weisen die funktionalisierten Lochleiter ebenfalls mindestens einen Rest aus der Gruppe der R_{V} oder aus der Gruppe der R_{F} auf. Gemäß dieser Ausführungsform werden die funktionalisierten p-Dotanden mit dem funktionalisierten Lochleiter umgesetzt, das heißt die die funktionalisierten p-Dotanden vernetzen mit den funktionalisierten Lochleitern. Damit werden kovalente Bindungen zwischen den funktionalisierten p-Dotanden und den funktionalisierten Lochleitern gebildet. Insbesondere werden die kovalenten Bindungen zwischen den Resten R_{V} oder R_{F} gebildet. Beispielsweise vernetzen 3 bis 10 oder 10 bis 100 funktionalisierte p-Dotanden und funktionalisierte Lochleiter untereinander, so dass mit anderen Worten das gebildete Netzwerk aus 3 bis 10 oder 10 bis 100 Monomereinheiten aufgebaut ist. Zusätzlich können die funktionalisierten p-Dotanden auch untereinander vernetzen und somit kovalente Bindungen untereinander ausbilden.

Es wurde überraschenderweise gefunden, dass dieses erfindungsgemäße Verfahren zu mechanisch sehr stabilen und chemisch inerten, organisch elektrischen Schichten führt, ohne dass man auf die Standardproduktionsprozesse der organischen Elektronik verzichten muss. Durch den Einsatz der erfindungsgemäß modifizierten p-Dotanden oder der erfindungsgemäß modifizierten p-Dotanden und der erfindungsgemäß modifizierten Lochleiter sind also nicht nur stabilere Schichten erhältlich, welche zum Beispiel eine geringere Kristallisationsneigung und damit eine verlängerte Haltbarkeit zeigen, sondern es lässt sich vielmehr auch eine deutlich größere Anzahl an möglichen Prozessschritten realisieren. Dies aufgrund der Tatsache, dass eine vernetzte im Vergleich zu einer unvernetzten Schicht chemisch und physikalisch stabiler ist. Insbesondere gilt dies für Nassprozesse, in denen nach dem Aufbau einer Schicht weitere Schichten im Rahmen eines Schichtverbundes abgeschieden werden. Üblicherweise erfordert das Abscheiden der weiteren Schichten eine strikte Auswahl der Lösungsmittel für die Verarbeitung der weiteren Schichten, um ein Auf- oder Anlösen der zuerst abgeschiedenen Schicht(en), ganzer oder einzelner Bestandteile daraus, zu vermeiden. Diese Restriktion bei der Auswahl der folgenden Lösungsmittel entfällt durch das erfindungsgemäße Verfahren und demzufolge können beim Abscheiden der weiteren Schichten eine deutlich größere Auswahl an Lösungsmitteln eingesetzt werden, welche nicht zwingend orthogonal sein müssen. Ein Auswaschen von Dotanden oder gar ein Herauslösen von Matrixbestandteilen, wie zum Beispiel Lochleitern, ist also nicht mehr möglich. Hierdurch sind also chemisch sehr wohldefinierte organisch elektrische Schichten mit einem konstanten Dotierungsverhältnis erhältlich. Ähnliche Vorteile ergeben sich auch bei der Herstellung von Schichten durch Vakuumverfahren. Durch die erfindungsgemäß erhältlichen chemisch und physikalisch inerten Schichten wird eine Diffusion von den Bestandteilen einer Schicht in eine andere Schicht deutlich minimiert, wenn nicht sogar ganz verhindert. Auf diese Art und Weise werden ungewollte Fehlstellen durch schichtfremde Substanzen in anderen Schichten vermieden. Ein weiterer Vorteil des Verfahrens ergibt sich dadurch, dass die Vernetzungsreaktion in einem hohen Maße steuerbar ist, weil die einzelnen Reaktionspartner vor ihrem Abscheiden chemisch modifiziert wurden. Es treffen also chemisch wohldefinierte Reaktionspartner, also die funktionalisierten p-Dotanden oder die funktionalisierten p-Dotanden und die funktionalisierten Lochleiter, aufeinander, welches zu einer homogenen Prozessführung und einer steuerbaren Reaktion beiträgt. Dies im Gegensatz zu Reaktionsführungen, in welchen die vernetzenden Spezies erst nach dem Abscheiden in einer Schicht in situ gebildet werden. Zusätzlich ist es durch den Einsatz chemisch definierter Vernetzungsmittel (p-Dotand oder p-Dotand und Lochleiter) möglich, eine definierte Schichtstruktur bereitzustellen. Bisher ergeben sich durch die gängigen Abscheideverfahren weniger feste Anbindungen der Reaktionspartner und somit eine mehr oder weniger feste Anordnung von p-Dotanden untereinander oder p-Dotand und Lochleiter innerhalb der Schichten. Durch den Einsatz funktionalisierender Gruppen an definierten Stellen der p-Dotanden oder der p-Dotanden und des Lochleiters kann eine direkte räumliche Beziehung zwischen den einzelnen Reaktionspartnern vorgegeben werden. Auf diese Art und Weise lässt sich der strukturelle Aufbau der Schicht vorherbestimmen. Es können sich also nicht nur länger haltbare, sondern auch strukturell bestimmbare Schichten ergeben. Dies kann zu einer verbesserten oder auch veränderten Funktionalität der Schicht beitragen.

Gemäß zumindest einer Ausführungsform werden funktionalisierte p-Dotanden untereinander vernetzt. Die funktionalisierten p-Dotanden vernetzen durch eine chemische Reaktion untereinander und bilden so ein Netzwerk. Insbesondere ab einer Konzentration von 16 Volumenprozent des p-Dotanden bezogen auf das Volumen des Lochleiters ist eine Vernetzung der p-Dotanden untereinander überraschenderweise ausreichend, um eine mechanisch sehr stabile und chemisch inerte vernetzte lochleitende elektrische Schicht zu bilden. Der Lochleiter wird hierbei sozusagen in dem Netzwerk eingeschlossen. Gemäß dieser Ausführungsform kann somit eine Funktionalisierung der Lochleiter nicht nötig sein, so dass herkömmliche, insbesondere nicht funktionalisierte Lochleiter eingesetzt werden können.

Gemäß zumindest einer Ausführungsform sind der oder die Substituenten R unabhängig voneinander aus oben genannter Gruppe ausgewählt, wobei insbesondere in dem Fall, in welchem R eine substituierte oder nicht-substituierte Alkyl- oder Aryl-Gruppe ist, die Substitution bevorzugt aus einer partiellen oder Perfluorierung der Alkyl- oder Aryl-Gruppe bestehen kann. Diese Substituierung kann zu einer besonders geeigneten elektronischen Struktur des Restes beitragen, mit welcher man in der Lage ist, die Lewis-Azidität des Gesamtkomplexes durchzustimmen.

Erfindungsgemäß tragen der p-Dotand oder der p-Dotand und der Lochleiter einen funktionalisierenden Rest aus der Gruppe der R_{F}, welcher natürlich gleichartig oder verschieden sein kann. Für den p-Dotanden trägt dieser funktionalisierende Rest aus der Gruppe der R_{F} mindestens ein organischer Ligand R_{V} oder die Gruppe G. Die funktionalisierenden Reste sind jeweils kovalent mit dem Liganden R_{V}, der Gruppe G des Dotanden oder dem Lochleiter verknüpft. Es ist auch möglich, dass der Rest R_{V} aus dem Rest R_{F} besteht. In dem Fall, dass der p-Dotand mehrere Liganden mit Resten R_{V} oder Gruppen G trägt, weist der p-Dotand natürlich mehrere funktionalisierende Reste R_{F} auf, da jeder der Liganden dann einen solchen funktionalisierenden Rest trägt. Die funktionalisierenden Reste des p-Dotanden oder des p-Dotanden und des Lochleiters sind dabei zweckmäßigerweise so ausgewählt, dass die funktionalisierenden Reste miteinander ebenfalls eine kovalente Verbindung eingehen können. Die zweckmäßigen Kombinationen geeigneter funktionalisierender Reste sind dabei dem Fachmann bekannt.

Insbesondere hat sich bei der hier angegebenen Gruppe der R_{F} gezeigt, dass diese mit den gängigen Lochleitern der organischen Elektronik und den erfindungsgemäß einsetzbaren p-Dotanden chemisch kompatibel sind. Diese funktionalisierenden Reste der Gruppe R_{F} lassen sich zudem mit den standardmäßigen Herstellungsverfahren verarbeiten, ohne dass es zu einer vorzeitigen Reaktion der funktionalisierenden Reste kommt. Zudem erfolgt die Umsetzung zwischen den hier angegebenen Resten im hohen Maße quantitativ und mit einer Reaktionsgeschwindigkeit, welche eine effiziente Herstellung ermöglicht. Ohne durch die Theorie gebunden zu sein ergeben sich diese Eigenschaften gerade durch die Anbindung des funktionalisierten Restes an die erfindungsgemäß einsetzbaren Liganden nach den Formeln I-V. Diese Verknüpfung des funktionalisierenden Restes an den Komplex führt dazu, dass sowohl die Vernetzungsreaktion in einem hohen Maße steuerbar ist, wie auch, dass die Funktion als p-Dotand nicht beeinträchtigt wird. Ein derartiger Effekt kann nicht erwartet werden, wenn die Anbindung des funktionalisierenden Restes an andere als die hier vorgesehenen erfindungsgemäßen Liganden erfolgt. Ohne durch die Theorie gebunden zu sein ergibt sich die Eignung der in diesem Verfahren einsetzbaren Liganden I-V aus einer Kombination der gewählten sterischen mit den elektronischen Eigenschaften. Insbesondere die räumliche Nähe der funktionalisierenden, vernetzenden Gruppe zu derjenigen Gruppe, welche die Koordination zum Metall-Zentralatom übernimmt (E), scheint dabei einen günstigen Einfluss, sowohl auf die Komplexbildung wie auch auf die Vernetzungsreaktion, auszuüben. Dieser Effekt lässt sich hochwahrscheinlich auf die direkte räumliche Nähe dieser Gruppen oder auf eine resonanzstabilisierende Anbindung zwischen diesen beiden Gruppen zurückführen. Des Weiteren ist die Gruppe der erfindungsgemäß einsetzbaren Liganden im hohen Maße geeignet, um mit den erfindungsgemäß einsetzbaren Metallatomen der Gruppen 6-15 sehr stabile Komplexe zu geben, wobei diese Gruppe an Liganden zudem zu einer geeigneten elektronischen Wechselwirkung mit dem Metall-Zentralatom befähigt sind. Ohne durch die Theorie gebunden zu sein geht die elektronische Wechselwirkung zwischen den erfindungsgemäß einsetzbaren Liganden und den Metallen über ein reine Komplexbildung hinaus, so dass auch eine Rückverteilung von Elektronendichte (oder weitere elektronische Wechselwirkungsmechanismen) von den Metallen auf die Liganden erfolgt. Dies ergibt sich wahrscheinlich durch eine geeignete Größe und Lewis-Azidität der hier genannten Metallgruppe und der geeigneten sterischen und elektronischen Ausgestaltung der hier angegebenen organischen Liganden. Es handelt sich demzufolge um eine passgenaue Kombination geeigneter Lewis-Säuren (Funktion der p-Dotierung) mit geeigneten Lewis-Basen (lochleitende Funktion), welche in Summe gute p-leitende, also lochleitende, Schichten und, falls funktionalisiert, gute vernetzende Eigenschaften aufweisen.

Im Sinne der vorliegenden Erfindung umfasst die Bezeichnung "p-Dotand" insbesondere Verbindungen, die immer mindestens ein Metall-Zentralatom der Gruppen 6-15 des Periodensystems und einen oder mehrere organische Liganden nach Formel I-V aufweisen, wobei erfindungsgemäß mindestens einer der organischen Liganden funktionalisiert, das heißt für die Vernetzung ausgerüstet ist. Die Liganden liegen in der Regel im Komplex mit dem Metall geladen vor und kompensieren so die Ladung des Metalls. Die Ladung des Liganden im Komplex ist dem Fachmann bekannt und wird in dieser Anmeldung nicht mit angezeigt. So kann es zum Beispiel vorkommen, dass zur Komplexbildung mit dem Metallatom ein Wasserstoffatom aus dem E des Liganden abgespalten wird, zum Beispiel wird dann aus einer OH-Gruppe ein O⁻. Des Weiteren ist dem Fachmann bekannt, dass die E der Liganden entweder einfach oder doppelt kovalent an den Liganden gebunden vorliegen können. Die Bindungsverhältnisse der E in den dargestellten Liganden sind demzufolge beispielhaft zu verstehen. Die Anzahl der weiteren kovalenten Bindungspartner E₁ ergibt sich für den Fachmann verständlich als Funktion der Anbindung des E. Ist E zum Beispiel formal nur einfach kovalent an den Liganden angebunden, zum Beispiel -N, so können natürlich zwei E₁-Einheiten an das Stickstoff gebunden sein - N(E₁)₂ oder -N(E₁)H. Liegt der Stickstoff aber doppelt gebunden vor =N, so ist natürlich nur eine E₁-Einheit =NE₁ oder eine negative Ladung =N⁻ vorhanden.

Unter dem Begriff "Metall aus den Gruppen 6-15 des Periodensystems" werden insbesondere die Metalle der 6. bis 15. Gruppe laut IUPAC, das heißt Cr, Mo, W, Mn, Tc, Re, Fe, Ru, Os, Co, Rh, Ir, Ni, Pd, Pt, Cu, Ag, Au, Zn, Cd, Hg, Al, Ga, In, Tl, Ge, Sn, Pb, As, Sb, Bi oder Mischungen daraus verstanden. Diese Metalle stellen eine ausreichende Lewis-Azidität zur Verfügung und ermöglichen so eine effektive p-Dotierung des Lochleiters. Des Weiteren ermöglichen diese Metalle eine besonders effektive Wechselwirkung mit den erfindungsgemäß einsetzbaren Liganden. Diese Reaktionsmöglichkeiten zeigen andere Metalle außerhalb dieser Gruppe nicht in diesem Umfang. Des Weiteren hat sich gezeigt, dass diese Metalle die Reaktionen der erfindungsgemäß funktionalisierten Liganden nicht beeinträchtigen. Dies ist aus dem Grund überraschend, da durch Veränderungen der Elektronendichte der funktionellen Gruppen zumindest auch ein größerer Einfluss des Metallatoms auf die Reaktionsgeschwindigkeit der Umsetzung der funktionalisierten Liganden unter sich oder mit dem funktionalisierten Lochleiter zu erwarten gewesen wäre.

Bevorzugt sind weiterhin die Metalle der Gruppe 14 und 15, das heißt Silizium, Germanium, Zinn, Blei, Arsen, Antimon, Bismut. Erfindungsgemäß bevorzugt sind weiterhin die Metalle ausgesucht aus der Gruppe umfassend oder bestehend aus Cu, Ag, Zn, Al, Sn, Sb, Bi. Ganz besonders bevorzugt ist das Metall Bismut.

Die Gruppe G ergibt sich zu -C(R_{F})ᵤHᵥF_{w} mit u+v+w = 3, wobei gemäß zumindest einer Ausführungsform die einzelnen Platzhalter u, v, w ganze Zahlen von 0 bis 3 darstellen und u mindestens 1 ist. Insbesondere lässt sich über die Anzahl der Fluoratome die Lewis-Azididät des Komplexes beeinflussen, welches zu einer verbesserten Dotierwirkung des Komplexes beitragen kann.

Als Lochleiter kommen prinzipiell die dem Fachmann bekannten Lochleiter beziehungsweise Lochleitergrundstrukturen infrage, welche im Falle der Verwendung eines funktionalisierten Lochleiters natürlich durch die erfindungsgemäße Funktionalisierung modifiziert sind. Als Lochleiter beziehungsweise Lochleitergrundstrukturen kommen beispielsweise folgende Verbindungen, oder Mischungen dieser Verbindungen, in Frage:
NPB (N,N'-Bis(naphthalen-1-yl)-N,N'-bis(phenyl)-benzidin), β-NPB N,N'-Bis(naphthalen-2-yl)-N,N'-bis(phenyl)-benzidin), TPD (N,N'-Bis(3-methylphenyl)-N,N'-bis(phenyl)-benzidin), Spiro TPD (N,N'-Bis(3-methylphenyl)-N,N'-bis(phenyl)-benzidin),
Spiro-NPB (N,N'-Bis(naphthalen-1-yl)-N,N'-bis(phenyl)-spiro), DMFL-TPD N,N'-Bis(3-methylphenyl)-N,N'-bis(phenyl)-9,9-dimethyl-fluoren),
DMFL-NPB (N,N'-Bis(naphthalen-1-yl)-N,N'-bis(phenyl)-9,9-dimethyl-fluoren),
DPFL-TPD (N,N'-Bis(3-methylphenyl)-N,N'-bis(phenyl)-9,9-diphenyl-fluoren),
DPFL-NPB (N,N'-Bis(naphthalen-1-yl)-N,N'-bis(phenyl)-9,9-diphenyl-fluoren),
Spiro-TAD (2,2',7,7'-Tetrakis(N,N-diphenylamino)- 9,9 '-spirobifluoren),
9,9-Bis[4-(N,N-bis-biphenyl-4-yl-amino)phenyl]-9H-fluoren,
9,9-Bis[4-(N,N-bis-naphthalen-2-yl-amino)phenyl]-9H-fluoren,
9,9-Bis[4-(N,N'-bis-naphthalen-2-yl-N,N'-bis-phenyl-amino)-phenyl]-9H-fluoren,
N,N'-bis (phenanthren-9-yl)-N,N'-bis (phenyl)-benzidin,
2,7-Bis[N,N-bis(9,9-spiro-bifluorene-2-yl)-amino]-9,9-spiro-bifluoren,
2,2'-Bis[N,N-bis(biphenyl-4-yl)amino]9,9-spiro-bifluoren,
2,2'-Bis(N,N-di-phenyl-amino)9,9-spiro-bifluoren,
Di-[4-(N,N-ditolyl-amino)-phenyl]cyclohexan,
2,2',7,7'-tetra(N, N-di-tolyl)amino-spiro-bifluoren,
N, N,N',N'-tetra-naphthalen-2-yl-benzidin.

Diese Verbindungen können neben ihrem Einsatz als Monomere auch in oligo- oder polymerer Form eingesetzt werden. Bevorzugterweise können dann die Oligomere oder Polymere ein Molekulargewicht von größer oder gleich 300 Da und kleiner oder gleich 500000 Da aufweisen, des Weiteren von größer oder gleich 3000 Da und kleiner oder gleich 100000 Da. So haben sich beispielsweise oben genannte Lochleitergrundstrukturen in diesem Molekulargewichtsbereich als besonders geeignet und zur erfindungsgemäßen Vernetzung als zugänglich erwiesen. Das Molekulargewicht des organischen Lochleiters lässt sich nach den gängigen Methoden zur Molekulargewichtsbestimmung erhalten. An dieser Stelle ist das gewichtsgemittelte Molekulargewicht aufgeführt, welches sich beispielsweise über GPC, Viskosimetrie oder durch andere rheologische Methoden bestimmen lässt. Des Weiteren kommt auch die Lichtstreuung zur Bestimmung des Molekulargewichts in Frage. Im Falle von Unterschieden zwischen den genannten Methoden soll der durch Streumethoden ermittelte Wert maßgeblich sein.

Gemäß zumindest einer Ausführungsform können die Grundstrukturen der Lochleiter die funktionalisierende Gruppe R_{F} oder die Gruppe R_{V} an jeder substitutionsfähigen Stelle ihrer Grundstruktur zeigen. Prinzipiell ist es auch möglich, dass diese Grundstrukturen mehr als eine funktionalisierende Gruppe aufweisen. Insbesondere kann es vorteilhaft sein, dass der Lochleiter aus Monomeren gebildet wird, wobei das Verhältnis von vernetzenden Gruppen zu Monomeren 0,0001-2, vorzugsweise 0,001-1, des Weiteren bevorzugt 0,01-1 beträgt. Das Verhältnis gibt die Anzahl der funktionalisierten Monomere an. Bei einem Verhältnis von 0,01 trägt jedes 100te Monomer in dem abgeschiedenen Lochleiter eine vernetzungsfähige Gruppe und bei einem Verhältnis von 1 weist jedes Monomer innerhalb des Lochleiters eine vernetzungsfähige Gruppe auf. Durch diese Verhältnisse lassen sich Schichten mit einer geeigneten Verarbeitbarkeit und Viskosität herstellen. Insbesondere kann eine höhere Funktionalisierung geeignet sein, um definierte dreidimensionale Schichtstrukturen auszubilden, deren abschließender Härtegrad sich über die Anzahl an Vernetzungsstellen leicht steuern lässt.

Die funktionalisierten p-Dotanden können untereinander und/oder die funktionalisierten p-Dotanden können mit den funktionalisierten Lochleitern nach dem Abscheiden in einer Schicht durch die gängigen Methoden der Chemie umgesetzt, das heißt miteinander zur Reaktion gebracht werden. Die vernetzenden Gruppen können radikalische, ring-öffnende beziehungsweise kondensierende Vernetzungsreaktionen auslösen. Das Umsetzen der beiden Reaktionspartner kann dabei sowohl spontan durch direkte Reaktion der beiden Reaktionspartner innerhalb der Schicht, durch einen äußeren Impuls oder aber auch durch Zusatz eines Starterreagenzes erfolgen. Mögliche Impulse sind beispielsweise das Erhitzen, das Bestrahlen mit Licht unterschiedlicher Wellenlänge oder Röntgenstrahlung, oder beliebige andere Impulse. Die Wahl des äußeren Startimpulses ergibt sich dabei als Funktion der Chemie der funktionalisierenden Gruppen und ist dabei dem Fachmann bekannt.

Gemäß zumindest einer Ausführungsform sind die p-Dotanden mit unterschiedlichen zur Vernetzung geeigneten Resten R_{F} subsituiert. Beispielsweise weisen die p-Dotanden innerhalb der Gruppe R_{V} oder G als R_{F} eine Epoxid- (Oxiran) oder Oxetangruppe auf. Die anderen p-Dotanden können dann innerhalb der Gruppe R_{V} oder G als R_{F} eine Amingruppe, beispielweise ein primäres oder sekundäres Amin, aufweisen. Die Amine können aliphatisch oder aromatisch sein. Bevorzugt sind aromatische Amine, da diese bei Raumtemperatur weniger zur Aushärtung neigen als aliphatische Amine.

Es werden die funktionalisierten p-Dotanden untereinander umgesetzt und vernetzt und die funktionalisierten p-Dotanden sind mit unterschiedlichen Resten R_{F} substituiert, wobei die einen p-Dotanden eine Epoxid- oder Oxetangruppe als R_{F} innerhalb von Rv oder G aufweisen und die anderen p-Dotanden eine NH₂-Gruppe oder NHR` als R_{F} innerhalb von R_{V} oder G aufweisen.

Beispielsweise kann R_{V} eine endständige Aminogruppe aufweisen und somit für mindestens einen Epoxid- oder Oxetangruppen enthaltenden p-Dotanden als Vernetzer dienen. In einer Additionsreaktion erhält man damit eine quervernetzte Schicht, die sich durch Addition der Aminogruppe des p-Dotanden und der Epoxid- oder Oxetangruppen des p-Dotanden ergibt. Zusätzlich findet unter dem Einfluss der Aminogruppen auch eine anionische Polymerisationsreaktion der Epoxid- oder Oxetangruppen selbst und damit eine weitere Vernetzung statt. Enthält R_{V} ein sekundäres Amin mit nur einem H-Atom, kann diese Einheit nur mit einer Epoxid- oder Oxetangruppe eines Rv eines weiteren p-Dotanden reagieren.

Beispielsweise kann R_{V} eine endständige Aminogruppe aufweisen und somit für einen mindestens zwei Epoxid- oder Oxetangruppen enthaltenden monomeren, oligomeren oder polymeren Lochleiter als Vernetzer dienen (siehe Schema I unten für Epoxidgruppen). In einer Additionsreaktion erhält man damit folgende quervernetzte Schicht, die sich durch Addition der Aminogruppe des p-Dotanden und der Epoxid- oder Oxetangruppen des Lochleiters ergibt. Zusätzlich findet unter dem Einfluss der Aminogruppen auch eine anionische Polymerisationsreaktion der Epoxid- oder Oxetangruppen selbst und damit eine weitere Vernetzung statt. Lochleiter enthalten meist Triarylamineinheiten, die katalytisch aktiv sein können. Enthält R_{V} ein sekundäres Amin mit nur einem H-Atom, kann diese Einheit nur mit einer Epoxid- oder Oxetangruppe eines Lochleiters reagieren. In dem Schema ist die Reaktion mit zwei Gruppen dargestellt. Bevorzugt sind aromatische Amine, da diese bei Raumtemperatur weniger zur Aushärtung neigen als manche aliphatischen Amine.

Alternativ dazu können sich die Epoxidgruppen am p-Dotand befinden und die Amingruppen mit freien H-Atomen am Lochleiter. Zudem können auch zwei oder mehr p-Dotanden mit Aminfunktionalität und/oder Epoxidfunktionalität gemischt werden, um auch unter den p-Dotanden eine zusätzliche Vernetzung zu erzielen. Gleiches gilt auch für die Lochleiter.

Alternativ werden die funktionalisierten p-Dotanden mit funktionalisierten Lochleitern umgesetzt. Die funktionalisierten Lochleiter weisen ebenfalls mindestens einen Rest aus der Gruppe R_{F} oder R_{V} auf, wobei die funktionalisierten p-Dotanden eine Epoxid- oder Oxetangruppe als R_{F} innerhalb von R_{V} oder G aufweisen und die funktionalisierten Lochleiter mindestens eine NH₂-Gruppe und/oder NHR`-Gruppe innerhalb der Gruppe R_{F} oder R_{V} aufweisen oder wobei die funktionalisierten p-Dotanden eine NH₂-Gruppe und/oder NHR`-Gruppe als R_{F} innerhalb von R_{V} oder G aufweisen und die funktionalisierten Lochleiter eine Epoxid- oder Oxetangruppe innerhalb der Gruppe R_{F} oder R_{V} aufweisen.

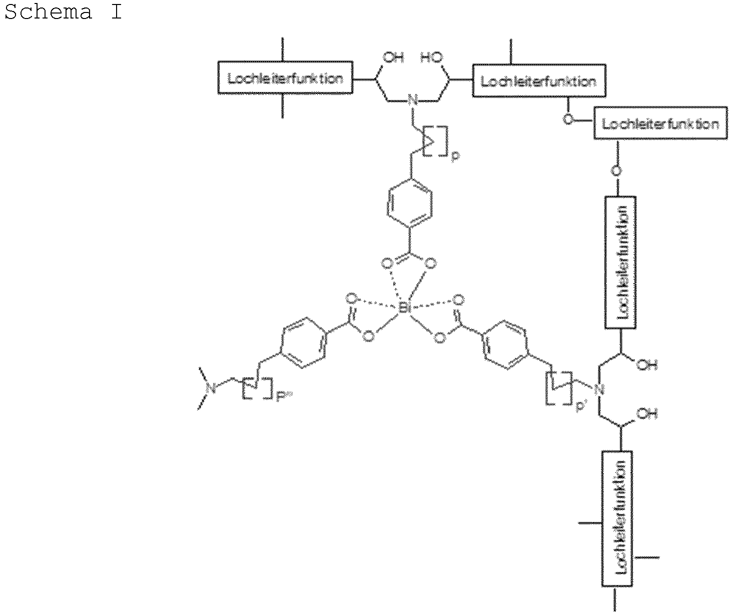

Gemäß zumindest einer Ausführungsform (nicht Teil der beanspruchten Erfindung) sind die p-Dotanden und/oder die p-Dotanden und der Lochleiter mit denselben zur Vernetzung geeigneten Resten R_{F} subsituiert. Beispielsweise handelt es sich dabei um eine Epoxidgruppe, eine Oxetangruppe oder eine Amingruppe, beispielsweise ein primäres oder sekundäres aromatisches oder aliphatisches Amin. Die Vernetzung findet dann unter Zugabe eines zusätzlichen Vernetzers statt. Bei dem Vernetzer kann es sich beispielsweise um eine mit zwei Amingruppen funktionalisierte Verbindung handeln, wenn R_{F} eine Epoxid- oder Oxetangruppe ist, und/oder um eine mit zwei Epoxid- oder Oxetangruppen funktionalisierte Verbindung, wenn R_{F} eine Amingruppe ist. Bevorzugt sind aromatische Amine, da diese bei Raumtemperatur weniger zur Aushärtung neigen als aliphatische Amine.

Gemäß zumindest einer Ausführungsform (nicht Teil der beanspruchten Erfindung) sind die p-Dotanden mit einer Epoxidgruppe und der Lochleiter mit einer Oxetangruppe funktionalisiert oder umgekehrt. Die Vernetzung findet dann unter Zugabe eines zusätzlichen Vernetzers statt. Bei dem Vernetzer kann es sich beispielsweise um eine mit zwei Amingruppen funktionalisierte Verbindung handeln. Bevorzugt sind aromatische Amine.

Innerhalb der Definition für den p-Dotanden sind substituierte oder nicht substituierte Liganden genannt. Im dem Falle, dass diese Verbindungen substituiert sind, bedeutet dieses, dass diese an jeder bindungsfähigen Stelle des Grundkörpers Halogene, D, C1-C10 Alkyle und substituierte oder unsubstituierte Heterozyklen aufweisen können. Vorzugsweise können die Substituenten aus Heterocyclen wie zum Beispiel Furan, Thiophen, Pyrrol, Oxazol, Thiazol, Imidazol, Isoxazol, Isothazol, Pyrazol, Pyridin, Pyrazin, Pyrimidin, 1,3,6 Triazin, Pyrylium, alpha-Pyrone, gamma-Pyrone, Benzofuran, Benzothiophen, Indol, 2H-Isoindol, Benzothiazol,2-Benzothiophene, 1H-Benzimidazole, 1H-Benzotriazole, 1,3-Benzoxazole, 2-Benzofuran, 7H-Purine, Chinolin, Iso-Chinolin, Quinazoline, Quinoxaline, Phthalazine, 1,2,4-Benzotriazine, Pyrido[2,3-d]pyrimidine, Pyrido[3,2-d]pyrimidine, Pteridine, Acridine, Phenazine, Benzo[g]pteridine, 9H-Carbazole, Bipyridin und deren Derivaten ausgewählt werden. Unter den Derivaten werden dabei auch insbesondere die fluorierten oder deuterierten Varianten dieser Verbindungen verstanden.

In einer bevorzugten Ausführungsform kann der p-Dotand, also der Metallkomplex Bismut, Zinn, Zink, Rhodium, Molybdän, Chrom oder Kupfer als Zentralatom umfassen. Insbesondere diese Auswahl an Metallen zeigt eine geeignete Lewis-Azidität, um zusammen mit den erfindungsgemäß einsetzbaren funktionalisierten Liganden sowohl eine schnelle und vollständige Vernetzungsreaktion zu ermöglichen, wie auch im vernetzten Zustand eine hinreichende Erhöhung der p-Leitfähigkeit zu induzieren. In einer weiteren erfindungsgemäßen Ausgestaltung kann der Metallkomplex ein oder mehrere Metalle aus der Gruppe bestehend aus Sn, Sb und Bi umfassen. Diese Metalle liefern besonders gute Dotierergebnisse und sind zu günstigen Preisen verfügbar.

In einer bevorzugten Ausgestaltung des Verfahrens kann der Metallkomplex Bismut, Zinn, Zink, Rhodium, Molybdän, Chrom oder Kupfer umfassen und mindestens einer der Liganden des p-Dotanden der Formel I entspricht. Insbesondere die Liganden nach der Formel I können geeignet sein, mit der oben angegebenen Gruppe an Metallen sehr stabile Komplexe auszubilden, welche zu einer effizienten p-Dotierung von Matrixmaterialien führen. Diese Fähigkeit wird anscheinend nicht durch das Einbringen der erfindungsgemäß einsetzbaren funktionalisierenden Reste beeinträchtigt, so dass sehr gut vernetzungsfähige und elektronisch geeignete p-Dotanden erhalten werden. Dies ist überraschenderweise trotzdem der Fall, obwohl durch die Möglichkeit der Resonanzstabilisierung eine Wechselwirkung zwischen der funktionalisierenden Gruppe und der Gruppe, welche die Anbindung an das Metallatom ermöglicht, zu erwarten wäre.

In einer besonderen Ausgestaltung der Erfindung kann jeder der Liganden des Metallkomplexes des p-Dotanden der Formel I entsprechen.

Gemäß zumindest einer Ausführungsform weist der p-Dotand folgende Formel A auf:

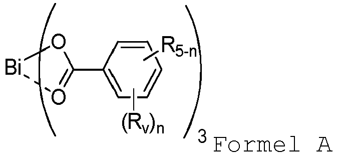

Die Verbindungen der Formel A lassen sich beispielsweise durch folgende Reaktion herstellen:

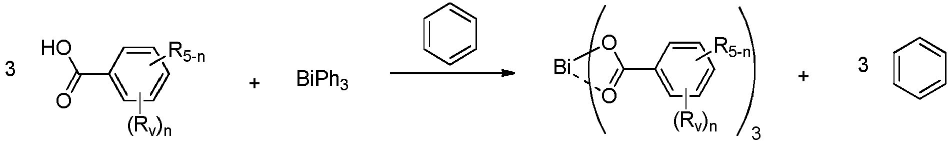

Die Umsetzung erfolgt in Benzol. BiPh₃ ist kommerziell erhältlich.

Beispielsweise weist der p-Dotand eine der folgenden Formeln A1, A2 oder A3 auf.

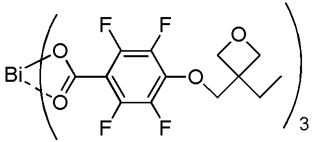

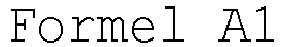

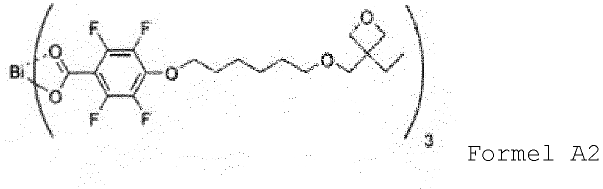

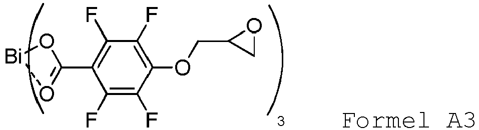

In einer besonderen Ausführungsform der Erfindung kann der Metallkomplex Zn, Cr, Cu oder Mo enthalten und mit dem Liganden als sogenannter Komplex mit Schaufelradstruktur ("Paddlewheel-Komplex") vorliegen. Hierbei handelt es sich bevorzugt um Carboxylat-Komplexe. Unter den Kupfermetallkomplexen bilden insbesondere die Cu(II)-Komplexe Paddlewheel-Komplexe, während Cu(I)-Komplexe vorwiegend tetramer, hexamer oder polymer vorliegen. Insbesondere diese Schaufelrad-Komplexgeometrie hat sich in dem erfindungsgemäßen Verfahren als besonders geeignet erwiesen, um geometrische Schichtstrukturen zu erhalten. Ohne durch die Theorie gebunden zu sein liegt das hochwahrscheinlich an der symmetrischen Struktur der p-Dotanden. Zudem scheint gerade diese Struktur in der Lage, die Lochleitfähigkeit der Schichten in hohem Ma-ße zu steigern. Geeignete Schaufelradstrukturen sind beispielsweise in der DE 10 2012 209520 angegeben. Im Erfindungssinne müssten diese Strukturen dann natürlich einen Liganden nach einer der Formeln I-V aufweisen, welcher erfindungsgemäß funktionalisiert ist.

Gemäß zumindest einer Ausführungsform entspricht mindestens einer Liganden des p-Dotanden folgender Formel VII oder VIII 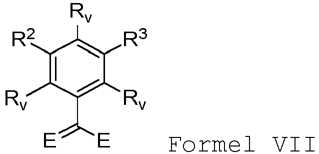 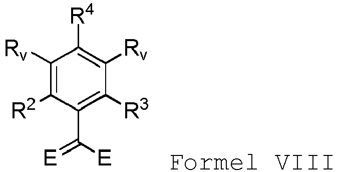 wobei
R² und R³ oder R², R³ und R⁴ unabhängig voneinander ausgewählt sind aus F und verzweigtem und unverzweigtem substituiertem Alkyl oder substituiertem Aryl. Bevorzugt sind R² und R³ oder R², R³ und R⁴ unabhängig voneinander ausgewählt aus F und verzweigte und unverzweigte, substituierte C1-C5 Alkyle. Bevorzugt handelt es sich bei R² und R³ oder R², R³ und R⁴ um elektronenziehende Reste. Dass es sich bei den Resten um elektronenziehende Reste handelt, bedeutet, dass sie Elektronendichte vom Arylring abziehen und damit eine höhere Elektronegativität als der Arylring aufweisen. Mittels den Liganden nach den Formel VII oder VIII lassen sich vernetzte Schichten erhalten, welche sowohl chemisch sehr stabil wie auch im hohen Maße p-leitend sind. Diese spezielle Struktur des Liganden ist geeignet, eine sehr effektive Anbindung des Liganden an das Metall-Zentralatom des Komplexes zu gewährleisten, ohne dabei eine anschließende Vernetzungsreaktion mit einem weiteren p-Dotanden oder dem Lochleiter zu stören. Ohne durch die Theorie gebunden zu sein, liegt das wahrscheinlich darin begründet, dass durch die elektronische Struktur und die sterische Ausdehnung des Liganden eine effektive Resonanzstabilisierung möglich ist. Dies kann die Aufnahme eines Elektrons durch den p-Dotanden und eine effektive Wechselwirkung mit dem Lochleiter erleichtern. Hinzu kommt noch, dass diese Liganden mit den erfindungsgemäß einsetzbaren Metallatomen recht stabile Komplexe ausbilden, welches beispielsweise ein unzersetztes Sublimieren der p-Dotanden ermöglicht. Anscheinend scheint diese Art der Liganden auch dazu geeignet, die Vernetzungsreaktion mit weiteren p-Dotanden oder dem Lochleiter auch in Gegenwart des Metallatoms zu kompensieren, so dass eine vollständige Umsetzung beider funktionalisierten Spezies ermöglicht wird.

In einer weiteren erfindungsgemäßen Charakteristik kann mindestens einer der Liganden des p-Dotanden folgender Formel VI entsprechen 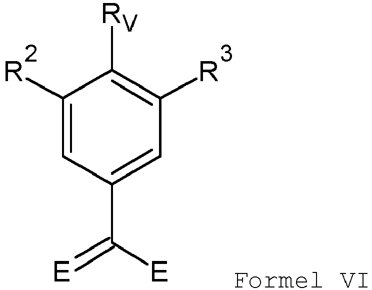 wobei
R² und R³ unabhängig voneinander ausgewählt sind aus F und verzweigtem und unverzweigtem substituiertem oder nicht substituiertem Alkyl oder substituiertem Aryl. Bevorzugt sind R² und R³ oder R², R³ und R⁴ unabhängig voneinander ausgewählt aus F und verzweigtem und unverzweigtem, substituiertem oder nicht substituiertem C1-C5 Alkyl. Bevorzugt handelt es sich bei R² und R³ um elektronenziehende Reste. Mittels der Liganden nach der Formel VI lassen sich vernetzte Schichten erhalten, welche sowohl chemisch sehr stabil wie auch im hohen Ma-ße p-leitend sind. Diese spezielle Struktur des Liganden ist anscheinend geeignet, eine sehr effektive Anbindung des Liganden an das Metallatom des Komplexes zu gewährleisten, ohne dabei eine anschließende Vernetzungsreaktion mit dem Lochleiter zu stören. Ohne durch die Theorie gebunden zu sein, liegt das wahrscheinlich darin begründet, dass durch die elektronische Struktur und die sterische Ausdehnung des Liganden eine effektive Resonanzstabilisierung möglich ist. Dies kann die Aufnahme eines Elektrons durch den p-Dotanden und eine effektive Wechselwirkung mit dem Lochleiter erleichtern. Hinzu kommt noch, dass diese Liganden mit den erfindungsgemäß einsetzbaren Metallatomen recht stabile Komplexe ausbilden, welches beispielsweise ein unzersetztes Sublimieren der p-Dotanden ermöglicht. Anscheinend scheint diese Art der Liganden auch dazu geeignet, die Vernetzungsreaktion mit weiteren p-Dotanden oder dem Lochleiter auch in Gegenwart des Metallatoms zu kompensieren, so dass eine vollständige Umsetzung beider funktionalisierten Spezies ermöglicht wird.

Beispielsweise weist der p-Dotand eine der folgenden Formeln A4, A5 oder A6 auf:

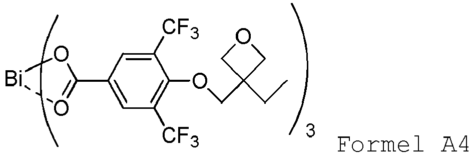

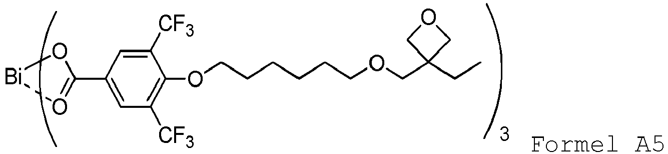

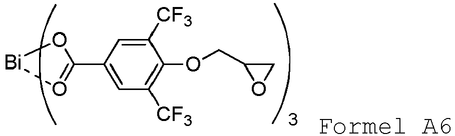

Gemäß zumindest einer Ausführungsform sind R² und R³ in den Formeln VI, VII oder R², R³, R⁴ in der Formel VIII unabhängig voneinander ausgewählt aus F und verzweigtem und unverzweigtem mindestens einfach, besonders bevorzugt per-, Halogensubstituiertem C1-C20-Alkyl, bevorzugt unabhängig voneinander ausgewählt aus F und der mindestens einfach, besonders bevorzugt per-, Halogen-substituierten C1-C5-Alkyle. Die Halogene können dabei aus einer Gruppe ausgewählt sein, die F, Cl, Br und Kombinationen daraus umfasst.

Gemäß zumindest einer Ausführungsform weist der Metallkomplex einen der folgenden Strukturausschnitte auf

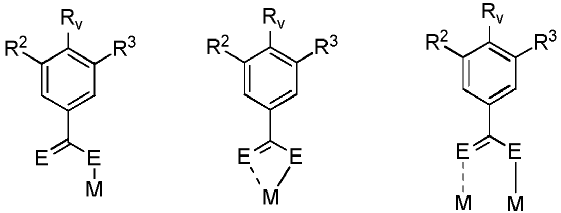

M steht beispielweise für Bismut, Zinn, Zink, Rhodium, Molybdän, Chrom oder Kupfer. Der Ligand kann also innerhalb des Metallkomplexes über eine kovalente Bindung an ein Metall-Zentralatom M gebunden sein oder der Ligand kann innerhalb des Metallkomplexes über eine kovalente Bindung und eine koordinative Bindung an ein Metall-Zentralatom M gebunden sein oder der Ligand kann über eine kovalente Bindung an ein Metall-Zentralatom M gebunden sein und über eine koordinative Bindung an ein weiteres Metall-Zentralatom M. Analoge Bindungsverhältnisse zwischen E und M sind auch für die Liganden der Formeln VII oder VIII möglich.

In einer besonderen Ausführungsform des Verfahrens können die E aus den Formeln I - VIII Sauerstoff sein. Carbonsäuren oder die Carboxylate haben sich im Rahmen des erfindungsgemäßen Verfahrens als besonders geeignet erwiesen, um einen stabilen p-Dotanden bereitzustellen, welcher sich unverändert prozessieren lässt und in der Lage ist, die Lochleitfähigkeit von Lochleitern deutlich zu erhöhen. Die Metallcarboxylate, insbesondere mit Kupfer oder Bismuth als Zentralatome, besitzen aufgrund ihrer Lewis-Azididät eine hervorragende Dotierstärke und eine hohe optische Transparenz. Die Effizienz und Lebensdauer von Bauelementen, insbesondere organischen lichtemittierenden Dioden umfassend eine vernetzte, lochleitende Schicht mit diesen funktionalisierten p-Dotanden, hat sich als besonders hoch erwiesen. Zudem sind solche vernetzte, lochleitende Schichten kostengünstig herstellbar. Bevorzugt handelt es sich um Benzoesäureliganden.

In einer besonderen Ausgestaltung des Verfahrens kann der Metallkomplex Bismut, Zinn, Zink, Rhodium, Molybdän, Chrom oder Kupfer umfassen und mindestens ein Ligand des p-Dotanden entspricht der Formel II. Die verknüpfende Einheit zwischen den Koordinationsstellen an das Metallatom (den E) und dem funktionalisierenden Rest kann bevorzugt als kurzkettiges Alkyl, in diesem Fall als einzelnes Kohlenstoffatom (im Grundgerüst), ausgestaltet sein. Diese Struktur kann gegebenenfalls auch fluoriert sein und scheint aufgrund seiner sterischen Ausgestaltung in der Lage, sowohl eine effektive Anbindung an das Metallzentrum, wie auch im erfindungsgemäßen Verfahren eine effektive Vernetzungsreaktion zu ermöglichen. Anscheinend hindert auch ein kurzes Grundgerüst zwischen den beiden oben genannten Gruppen nicht die freie Beweglichkeit des funktionalisierenden Restes, so dass auch die Vernetzungsreaktion effizient ablaufen kann.

In einer bevorzugten Ausführungsform des Verfahrens kann der Metallkomplex Bismut, Zinn, Zink, Rhodium, Molybdän, Chrom oder Kupfer umfassen und mindestens ein Ligand des p-Dotanden entspricht der Formel III. Neben einem Grundgerüst aus Kohlenstoffatomen lassen sich für das erfindungsgemäße Verfahren auch Schwefelatome nutzen, welche die Verbindung zwischen der koordinierenden Gruppe und der vernetzenden Gruppe bereitstellen. Überraschenderweise hat sich gezeigt, dass auch der Schwefel eine geeignete elektronische Struktur aufweist, welche sowohl die anschließende Vernetzungsreaktion nicht hindert, als auch die Lewis-Azidität des Metallatoms günstig beeinflusst.

In einer weiteren Charakteristik des Verfahrens kann der Metallkomplex Bismut, Zinn, Zink, Rhodium, Molybdän, Chrom oder Kupfer umfassen und mindestens ein Ligand des p-Dotanden entspricht der Formel IV. Diese Gruppe an Metallen ist in der Lage, mit den Liganden nach Formel IV Komplexe auszubilden, welche eine geeignete elektronische Struktur bereitstellen, um von dem Lochleiter Elektronen- oder Elektronendichte auszunehmen. Des Weiteren wird diese Eigenschaft durch das Vorhandensein der erfindungsgemäßen funktionalisierenden Gruppen in nur sehr geringem Maß beeinträchtigt, sodass es zu einer schnellen und vollständigen Vernetzungsreaktion zwischen den p-Dotanden untereinander und/oder mit dem Lochleiter kommen kann.

In einer weiteren, erfindungsgemäßen Ausgestaltung des Verfahrens kann der Metallkomplex Bismut, Zinn, Zink, Rhodium, Molybdän, Chrom oder Kupfer umfassen und mindestens ein Ligand des p-Dotanden entspricht der Formel V. Erfindungsgemäß lassen sich an einen Liganden auch mehrere funktionalisierende Gruppe koppeln, sodass es zu einer besonders hochvernetzten Schicht führen kann. Dieser Ligand stellt explizit mehrere dieser funktionalisierenden Gruppen bereit. Es lässt sich somit auch ein Ligand an mehrere Lochleitermoleküle koppeln, welches zu einer verstärkten elektronischen Wechselwirkung zwischen p-Dotand und Lochleiter führen kann.

In einer zusätzlichen Ausgestaltung des Verfahrens können die Reste R² und R³ oder G oder R² und R³ und R⁴ jeweils mindestens einfach fluoriert sein. Insbesondere die Fluorsubstitution der Reste R², R³ oder G oder R² und R³ und R⁴ kann zu einer besonders effizienten Steigerung der Lochleitfähigkeit der vernetzten Schicht beitragen. Ohne durch die Theorie gebunden zu sein, ergibt sich dies hochwahrscheinlich dadurch, dass durch die Substitution die Lewis-Azidität des gesamten p-Dotanden durchgestimmt werden kann, so dass eine besonders effiziente Aufnahme eines Elektrons oder von Elektronendichte aus dem Lochleiter erhalten wird. Dieser Mechanismus kann demzufolge zu einer Erhöhung der Schichtleitfähigkeit der vernetzten Schicht beitragen. Ohne durch die Theorie gebunden zu sein, kann dies insbesondere durch den starken -I-Effekt der Fluorsubstituierten Reste R², R³, R² und R³ und R⁴ oder G erreicht werden.

In einer weiteren bevorzugten Ausführungsform des Verfahrens können die Reste R² und R³ oder G oder R² und R³ und R⁴ perfluoriert sein. Bevorzugt sind R², R³ oder R² und R³ und R⁴ = CF₃. Die Verwendung von Liganden mit perfluorierten Resten R², R³ oder G oder R² und R³ und R⁴ kann zu Metallkomplexen führen, welche besonders gut mit Lochleitern wechselwirken und derart in der Lage sind, zu einer deutlichen Erhöhung der Lochleitfähigkeit der vernetzten Schichten beizutragen. Ohne durch die Theorie gebunden zu sein, liegt dies hochwahrscheinlich an der Elektronegativität des Fluors, welches in den gezeigten Liganden in der Lage ist, die Lewis-Azidität des Komplexes deutlich zu steigern. Die Steigerung der Lewis-Azidität führt im Rahmen des Schichtaufbaus und der Vernetzung zu einer Erhöhung der Lochleitfähigkeit der organisch elektrischen Schicht.

In einer weiteren Ausgestaltung kann jeder der Liganden eine Struktur nach Formel VI, VII oder VIII aufweisen und die R² und R³ oder R² und R³ und R⁴ jeweils unabhängig voneinander ausgewählt sein aus der Gruppe der verzweigten und unverzweigten, mindestens einfach, besonders bevorzugt per-, Fluor-substituierten C1-C5 Alkyle.

Innerhalb eines zusätzlichen erfindungsgemäßen Aspektes können die Reste R_{F} oder Rv folgende Reste Q1a bis Q26c umfassen oder aus diesen Resten bestehen 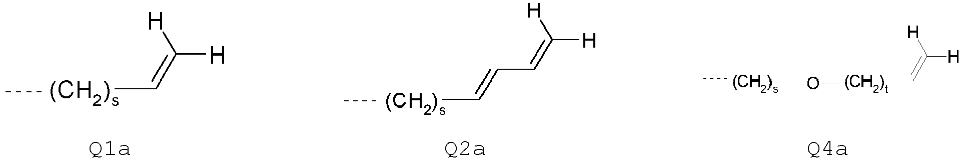 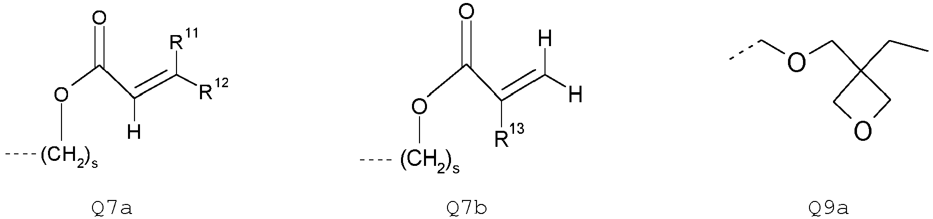 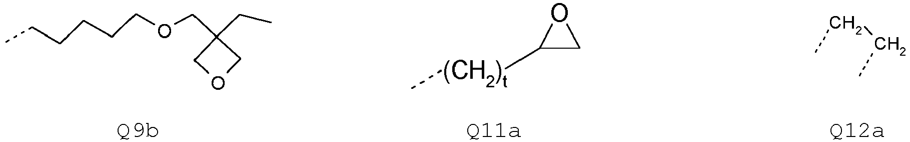 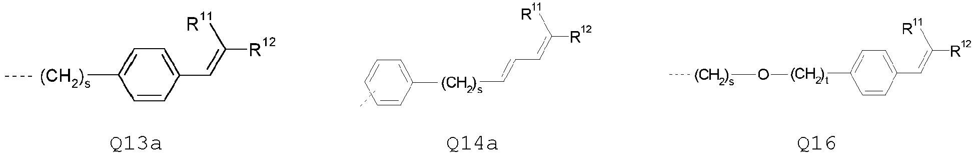 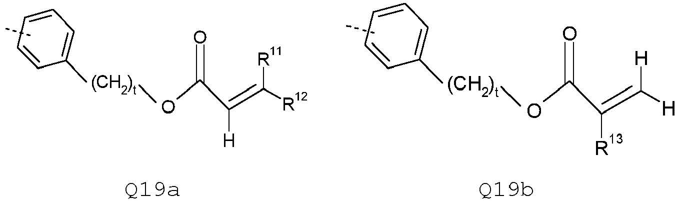 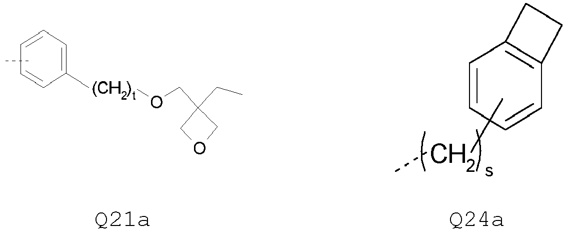 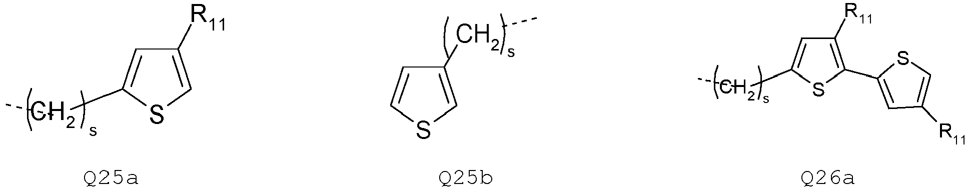 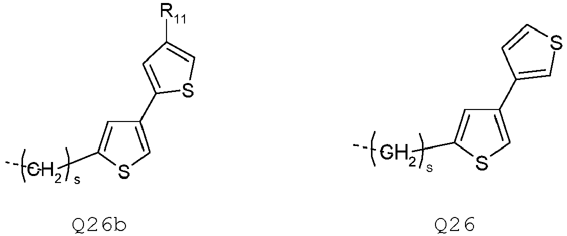 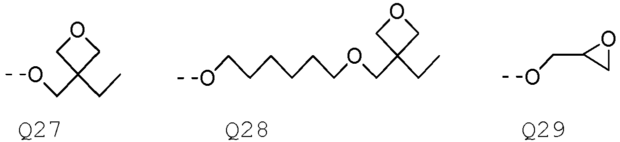 wobei die Reste R¹¹ und R¹² gleich oder verschieden sein können und ausgewählt sind aus der Gruppe umfassend H, D oder ein geradkettiges oder verzweigtes C1-C6 Alkyl, R¹³ ein geradkettiges oder verzweigtes C1-C6 Alkyl ist, s = 0 bis 8 ist und t = 1 bis 8 beträgt. Diese funktionellen Reste R_{F} oder Rv lassen sich mit den gängigen Methoden der Chemie sowohl an die erfindungsgemäß einsetzbaren Liganden des p-Dotanden wie auch an die erfindungsgemäß einsetzbaren Lochleiter koppeln. Es ergeben sich funktionalisierte Liganden und funktionalisierte Lochleiter, welche im hohen Maße temperaturstabil sind und welche sich aus diesem Grund über einen weiten Temperaturbereich verarbeiten lassen. Dadurch wird die Prozessführung im Rahmen des Schichtaufbaus vereinfacht und sichergestellt, dass die funktionalisierten Reste erst innerhalb der Schicht mit dem gewünschten Reaktionspartner reagieren. Dies kann zu einer effizienteren Vernetzung der Schicht beitragen.

In einer weiteren Ausführungsform des Verfahrens können die Reste R_{F} oder Rv folgende Reste Q1b bis Q26g umfassen oder aus diesen Resten bestehen:

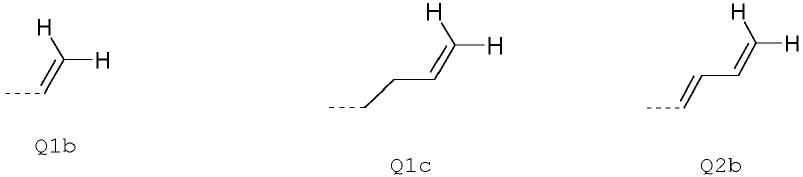

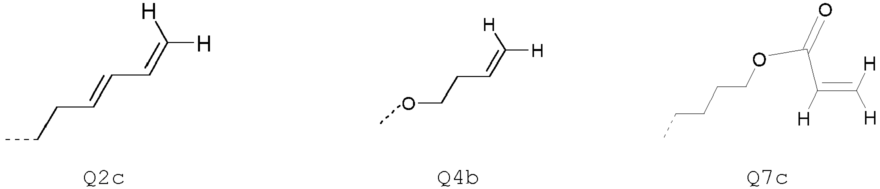

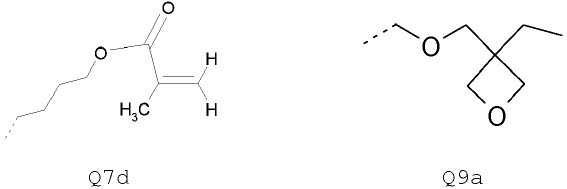

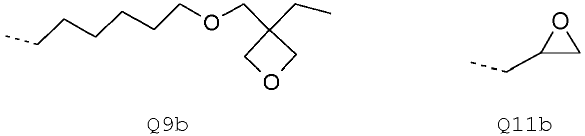

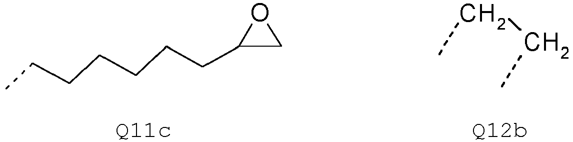

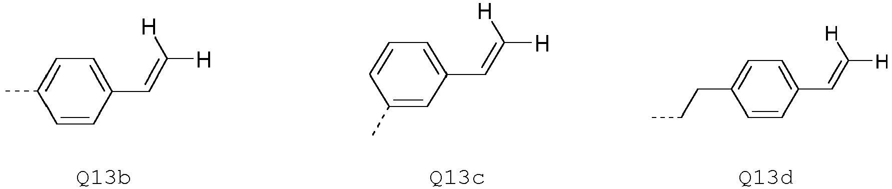

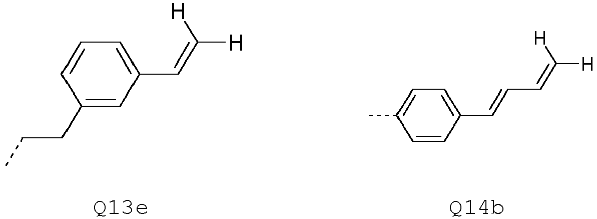

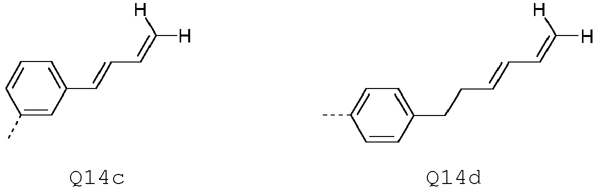

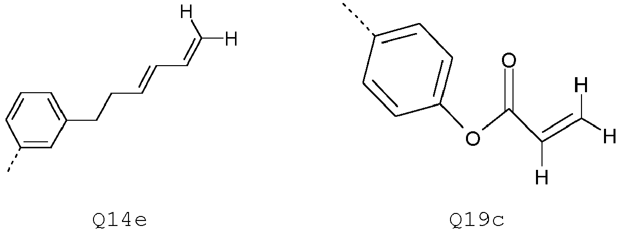

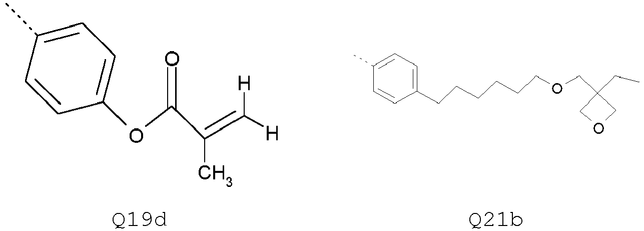

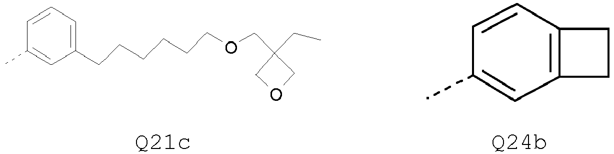

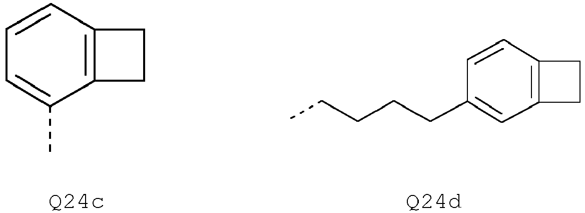

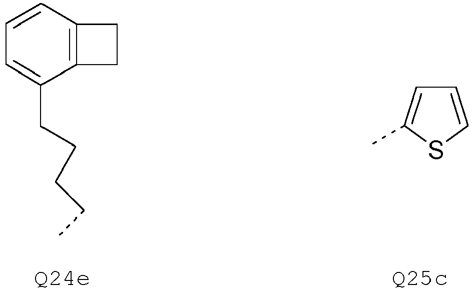

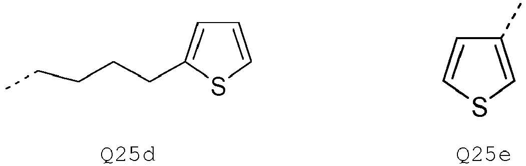

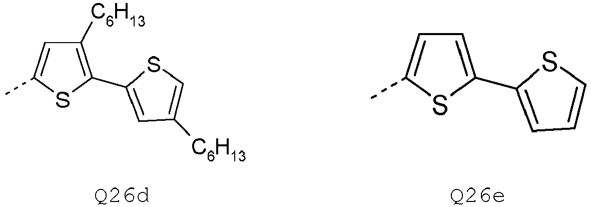

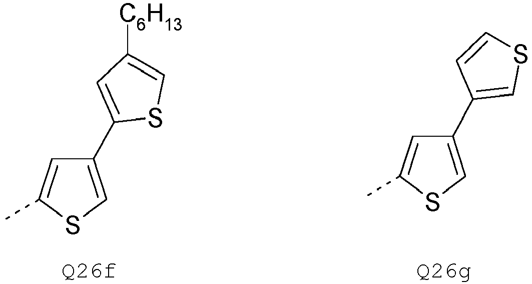

Diese funktionalisierenden Reste zeigen eine quantitative und sehr schnelle Umsetzung im Rahmen der erfindungsgemäßen Vernetzungsreaktion, wobei die kovalenten Brücken zwischen den erfindungsgemäß funktionalisierten p-Dotanden untereinander und/oder zwischen den erfindungsgemäß funktionalisierten p-Dotanden und den erfindungsgemäß funktionalisierten Lochleitern anscheinend einer effektiven Dotierung nicht entgegenstehen. Der Übertrag elektrischer Ladungen vom p-Dotanden zum Lochleiter wird also durch die kovalente Verknüpfung nicht gehindert. Daher ist es möglich, mit geringen Konzentrationen an p-Dotanden ausreichend p-leitfähige Schichten herzustellen.

Eine weitere erfindungsgemäße Ausgestaltung beinhaltet ein Verfahren mit einem erfindungsgemäßen p-Dotanden oder Lochleiter, wobei zwischen dem Liganden oder dem Lochleiter und dem funktionalisierenden Rest aus der Gruppe R_{F} ein zusätzlicher Linker angeordnet ist, wobei der Linker ausgewählt ist aus der Gruppe umfassend fluorierte oder nicht fluorierte C1-C20-, bevorzugt C1-C10-Alkyl, -Alkenyl, -Alkinyl, Polyethylenglykol, Polyethylendiamin, Polyester, Polyurethan, Polyvinylidenphenylen oder Gemischen daraus. Die C1-C20-Alkenylgruppen können konjugierte oder nicht-konjugierte Doppelbindungen aufweisen. Die C1-C20-Alkinylgruppen können konjugierte oder nicht-konjugierte Dreifachbindungen aufweisen und können beispielsweise mit Aromaten substituiert sein. Die genannten Linker können Aromaten oder Polyene in ihrer Molekülkette aufweisen. Innerhalb bestimmter Ausgestaltungen hat es sich als nützlich erwiesen, dass der Abstand zwischen dem funktionalisierenden Rest R_{F} und dem Liganden des Metallkomplexes erhöht wird. Ohne durch die Theorie gebunden zu sein führt dies dazu, dass der funktionalisierte Rest insgesamt beweglicher ist und so eine Vernetzungsreaktion mit einem anderen funktionalisierten Rest erleichtert wird. Auf diese Art und Weise lassen sich sowohl die Reaktionskinetik wie auch die mechanischen Eigenschaften der resultierenden vernetzten Schicht beeinflussen. Die ausgewählte Gruppe an Linker-Verbindungen gewährleistet dabei eine hinreichende elektrische Wechselwirkung zwischen dem p-Dotanden und dem Lochleiter, so dass die Effektivität der Dotierung nicht eingeschränkt wird.

In einem weiteren erfindungsgemäßen Aspekt kann die Einheit aus funktionalisierendem Rest und Linker, insbesondere der Rest R_{V}, ausgesucht sein aus der Gruppe umfassend Q13 - Q26 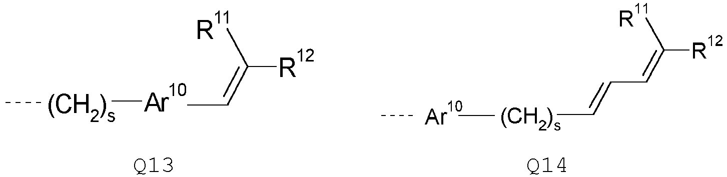 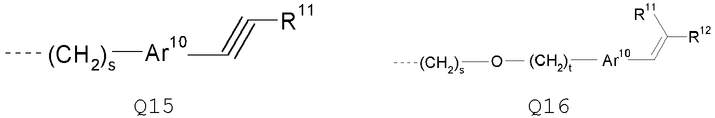 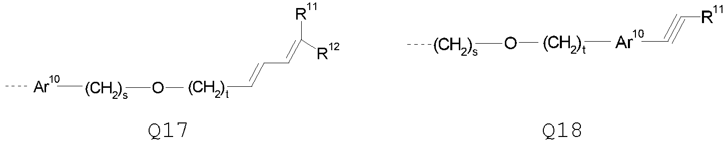 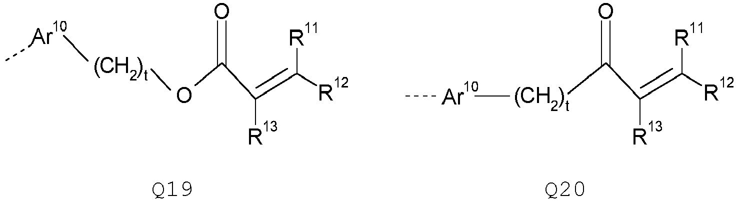 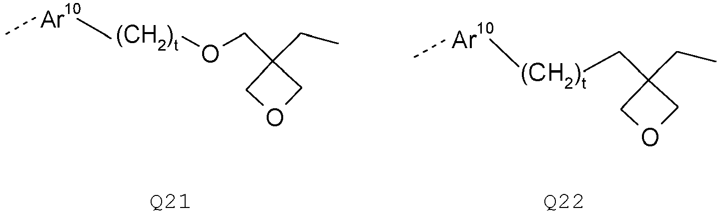 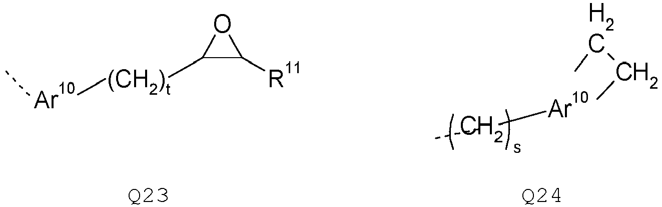 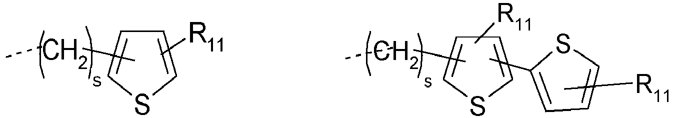 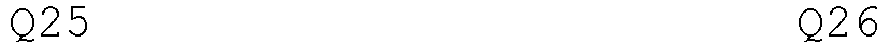 wobei Ar¹⁰ ein mono- oder polycyclisches, aromatisches oder heteroaromatisches C5-C60 Ringsystem ist. Bevorzugt ist Ar¹⁰ ein mono- oder polycyclisches, aromatisches oder heteroaromatisches C5-C10 Ringsystem. Diese Linker-Verbindungen zeigen zusammen mit den funktionalisierenden Gruppen sowohl eine ausreichende Reaktionskinetik, einen ausreichenden Umsetzungsgrad und eine effektive elektronische Wechselwirkung zwischen den p-Dotanden untereinander und/oder mit dem Lochleiter. Demzufolge führen diese Kombinationen zu besonders geeigneten lochleitenden Schichten mit einer hohen chemischen und physikalischen Stabilität und besonders geeigneten elektrischen Eigenschaften.

Zur Verdeutlichung des erfindungsgemäßen Konzeptes seien beispielhaft folgende Strukturen für mögliche p-Dotanden angegeben: 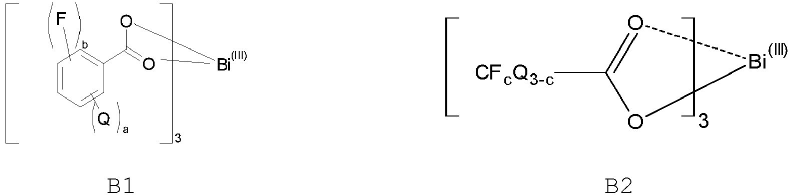 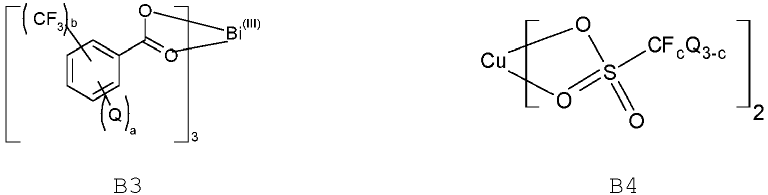 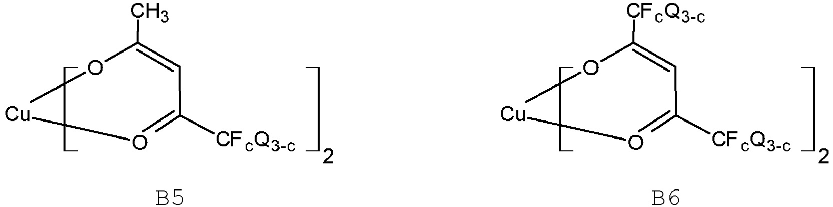 wobei
a = 1-4 sein kann und b ≤ 5-a und mindestens 1,
c = 1 oder 2 sein kann und
Q aus den Resten Q1 bis Q29 gewählt ist oder in speziellen Ausgestaltungen weiter unten definiert ist.

Weitere Ausgestaltungen der einsetzbaren p-Dotanden ergeben sich beispielsweise zu

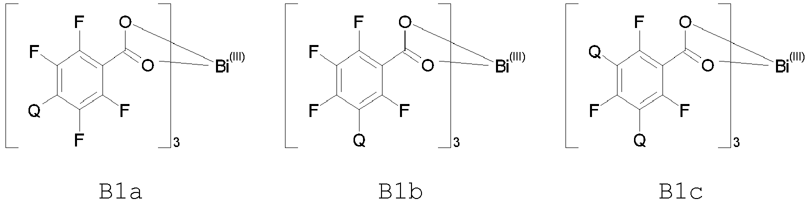

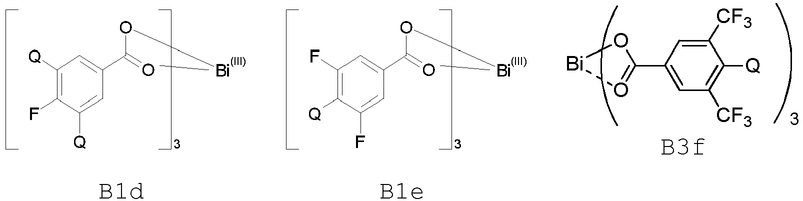

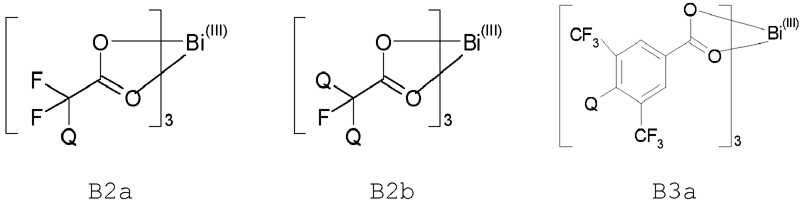

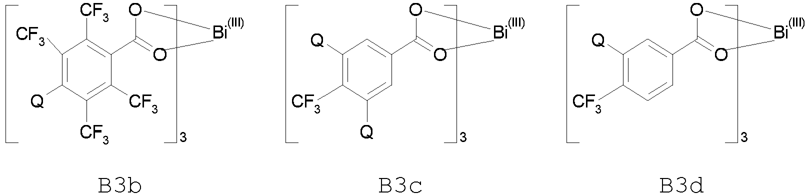

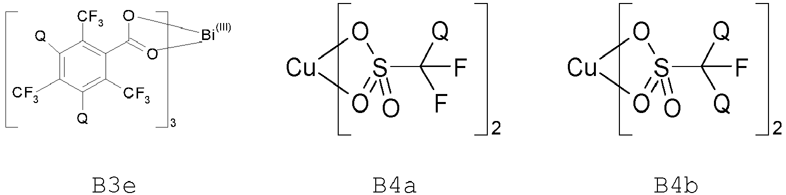

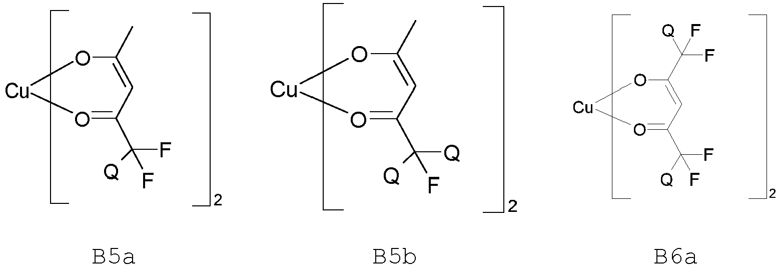

Man erkennt den Aufbau des erfindungsgemäß einsetzbaren p-Dotanden, in welchem mindestens ein Metall und ein oder mehrere Liganden vorliegen, wobei mindestens einer der Liganden eine Struktur nach Formel I-VIII mit einer funktionalisierenden Gruppe aufweist. Insbesondere ist auch dargestellt, dass die substituierbaren H-Atome der Liganden durch F-Atome ersetzt werden können.

Natürlich lassen sich auch die unterschiedlichen Strukturen aus funktionalisierender Gruppe und Ligand miteinander kombinieren. So können sich zum Beispiel unterschiedliche p-Dotanden durch Kombination der oben angegebenen Komplexe mit unterschiedlich funktionalisierenden Resten ergeben. Als erfindungsgemäß sind beispielhaft folgende Kombinationen genannt (Bezeichnung für den Gesamtkomplex (Kv), Grundstruktur des Dotanden (B), funktionalisierende Gruppe(Q)):
Kv1,B1,Q2; Kv2,B1,Q9; Kv3,B1,Q13; Kv4,B1,Q14; Kv5,B1,Q16; Kv6,B1,Q21; Kv7,B1,Q23; Kv8,B1,Q24; Kv9,B1,Q25; Kv10,B1,Q26; Kv11,B2,Q1; Kv12,B2,Q2; Kv13,B2,Q9; Kv14,B2,Q10; Kv15,B2,Q15; Kv16,B2,Q17; Kv17,B2,Q22; Kv18,B3,Q3; Kv19,B3,Q12;
Kv20,B3,Q4; Kv21,B3,Q13; Kv22,B3,Q9; Kv23,B3,Q7; Kv24,B3,Q2; Kv25,B3,Q11; Kv26,B3,Q14; Kv27,B3,Q16; Kv28,B3,Q21; Kv29,B3,Q24; Kv30,B3,Q25; Kv31,B4,Q13; Kv32,B4,Q19; Kv33,B4,Q22; Kv34,B5,Q2; Kv35,B5,Q7; Kv36,B5,Q8; Kv37,B5,Q26; Kv38,B5,Q13; Kv39,B6,Q1; Kv40,B6,Q2; Kv41,B6,Q6; Kv42,B6,Q9; Kv43,B6,Q13; Kv44,B6,Q20; Kv45,B6,Q21; Kv46,B6,Q24; Kv47,B6,Q26; Kv48,B6,Q5; Kv49,B6,Q18; Kv50,B1,Q27; Kv51,B1,Q28; Kv52,B1,Q29; Kv50,B3,Q27; Kv51,B3,Q28; Kv52,B3,Q29
Weitere, bevorzugte p-Dotanden ergeben sich zu: Kv1a,B1a,Q2a; Kv2a,B1a,Q9b; Kv3a,B1a,Q27; Kv4a,B1a,Q28; Kv5a,B1a,Q29; Kv1f,B3f,Q27; Kv2f,B3f,Q28; Kv3f,B3f,Q29;Kv2b,B1e,Q9a; Kv3a,Ble,Q13a; Kv3b,B1a,Q13a; Kv6a,B1c,Q21a; Kv8a,B1d,Q24a; Kv9a,B1e,Q25a; Kv10a,B1a,Q26b; Kv10b,B1a,Q26a; Kv12a,B2a,Q2a; Kv13a,B2a,Q9b; Kv13b,B2b,Q9a; Kv19a,B3d,Q12a; Kv20a,B3a,Q4a; Kv21a,B3a,Q13a; Kv21b,B3b,Q13a; Kv22a,B3e,Q9a; Kv22b,B3a,Q9b; Kv24a,B3c,Q2a; Kv25a,B3d,Q11a; Kv26a,B3a,Q14a; Kv27a,B3b,Q16a; Kv28a,B3e,Q21a; Kv29a,B3a,Q24a; Kv30a,B3e,Q25a; Kv31a,B4a,Q13a; Kv32a,B4a,Q19b; Kv32b,B4b,Q19b; Kv34a,B5a,Q2a; Kv35a,B5a,Q7a; Kv35b,B5b,Q7b; Kv37a,B5a,Q26a; Kv38a,B5a,Q13a; Kv39a,B6a,Q1a; Kv40a,B6a,Q2a; Kv42a,B6a,Q9a; Kv42b,B6a,Q9b.

Beispielsweise weist also der p-Dotand Kv3a folgende Struktur auf:

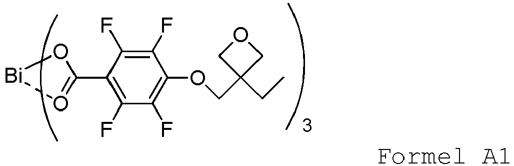

Besonders bevorzugte, erfindungsgemäße p-Dotanden ergeben sich zu:
Kv1b,B1a,Q2b; Kv1c,B1a,Q2c; Kv2a,B1a,Q9b; Kv2b,B1a,Q9a; Kv3a,B1a,Q27; Kv4a,B1a,Q28; Kv5a,B1a,Q29; Kv1f,B3f,Q27; Kv2f,B3f,Q28; Kv3f,B3f,Q29; Kv3c,B1e,Q13b; Kv3d,B1e,Q13c; Kv3e,B1e,Q13d; Kv3f,B1e,Q13e; Kv3g,B1a,Q13b; Kv3h,B1a,Q13c; Kv6b,B1c,Q21b; Kv6c,B1c,Q21c; Kv8b,B1d,Q24b; Kv8c,B1d,Q24c; Kv8d,B1d,Q24d; Kv9b,B1e,Q25c; Kv10c,B1a,Q26e; Kv10d,B1a,Q26g; Kv12b,B2a,Q2c; Kv13a,B2a,Q9b; Kv13b,B2b,Q9a; Kv19a,B3d,Q12a; Kv20a,B3a,Q4b; Kv21c,B3a,Q13b; Kv21d,B3a,Q13d; Kv21e,B3b,Q13e; Kv22a,B3e,Q9a; Kv22b,B3a,Q9b; Kv24b,B3c,Q2c; Kv26b,B3a,Q14b; Kv26c,B3a,Q14c; Kv28b,B3e,Q21b; Kv28c,B3e,Q21c; Kv29b,B3a,Q24b; Kv29c,B3a,Q24c; Kv29d,B3a,Q24e; Kv30b,B3e,Q25c; Kv30c,B3e,Q25e; Kv31b,B4a,Q13c; Kv31c,B4a,Q13d; Kv32c,B4a,Q19c; Kv32d,B4a,Q19d; Kv34b,B5a,Q2c; Kv35c,B5a,Q7c; Kv35d,B5b,Q7d; Kv37b,B5a,Q26d; Kv38b,B5a,Q13b; Kv38c,B5a,Q13e; Kv39b,B6a,Q1b; Kv40b,B6a,Q2c; Kv42a,B6a,Q9a; Kv42b,B6a,Q9b.

Diese Liganden-/Reste-Kombinationen ergeben besonders effektive p-Dotanden, welch sich besonders gut im Rahmen von Nassprozessen einsetzen lassen und zu hochvernetzten Schichten führen.

In einer zusätzlichen Charakteristik des Verfahrens kann zwischen dem Liganden oder dem Lochleiter und dem funktionalisierenden Rest aus der Gruppe R_{F} ein Linker angeordnet sein, wobei der Linker ausgewählt ist aus 1 - 10 kovalent verknüpften Einheiten aus der Gruppe umfassend N, N'-Bis(naphthalen-1-yl)-N,N'-bis(phenyl)-9,9-dimethyl-fluorene, N, N'-Bis(3-methylphenyl)-N,N'-bis(phenyl)-9,9-diphenyl-fluorene, N, N'-Bis(naphthalen-1-yl)-N,N'-bis(phenyl)-9,9-diphenyl-fluorene, N, N'-Bis(naphthalen-1-yl)-N,N'-bis(phenyl)-2,2-dimethylbenzidine, N, N'-Bis(3-methylphenyl)-N,N'-bis(phenyl)-9,9-spirobifluorene, 2,2',7,7'-Tetrakis(N, N-diphenylamino)-9,9'-spirobifluorene, N, N'-Bis(naphthalen-1-yl)-N,N'-bis(phenyl)-benzidine, N, N'-Bis(naphthalen-2-yl)-N,N'-bis(phenyl)-benzidine, N, N'-Bis(3-methylphenyl)-N,N'-bis(phenyl)-benzidine, N, N'-Bis(3-methylphenyl)-N,N'-bis(phenyl)-9,9-dimethyl-fluorene, N, N'-Bis(naphthalen-1-yl)-N,N'-bis(phenyl)-9,9-spirobifluorene, Di-[4-(N,N-ditolyl-amino)-phenyl]cyclohexane, 2,2',7,7'-tetra(N, N-di-tolyl)amino-spiro-bifluorene, 9,9-Bis[4-(N,N-bis-biphenyl-4-yl-amino)phenyl]-9H-fluorene, 2,2',7,7'-Tetrakis[N-naphthalenyl(phenyl)-amino]-9,9-spirobifluorene, 2,7-Bis[N,N-bis(9,9-spiro-bifluorene-2-yl)-amino]-9,9-spirobifluorene, 2,2'-Bis[N,N-bis(biphenyl-4-yl)amino]-9,9-spirobifluorene, N, N'-bis(phenanthren-9-yl)-N,N'-bis(phenyl)-benzidine, N, N,N',N'-tetra-naphthalen-2-yl-benzidine, 2,2'-Bis(N,N-diphenyl-amino)-9,9-spirobifluorene, 9,9-Bis[4-(N,N-bis-naphthalen-2-yl-amino)phenyl]-9H-fluorene, 9,9-Bis[4-(N, N'-bis-naphthalen-2-yl-N,N'-bis-phenyl-amino)-phenyl]-9H-fluorene, Titanoxidphthalocyanine, Kupferphthalocyanine, 2,3,5,6-Tetrafluoro-7,7,8,8,-tetracyano-quinodimethane, 4,4',4" -Tris(N-3-methylphenyl-N-phenyl-amino)triphenylamine, 4,4',4" -Tris(N-(2-naphthyl)-N-phenyl-amino)triphenylamine, 4,4',4" -Tris(N-(1-naphthyl)-N-phenyl-amino)triphenylamine, 4,4',4" -Tris(N,N-diphenyl-amino)triphenylamine, Pyrazino[2,3-f][1,10]phenanthroline-2,3-dicarbonitrile, N, N,N',N' -Tetrakis(4-methoxyphenyl)benzidine oder Mischungen daraus. Durch die Auswahl dieser speziellen Linker-Moleküle können flexible funktionalisierte Liganden und Lochleiter erhalten werden, bei denen sowohl der Abstand der funktionalisierten Gruppe vom Lochleiter oder Liganden frei bestimmbar und die Fähigkeit zur Lochleitung in nur einem äußerst geringen Maße eingeschränkt ist. Dies ermöglicht selbst den Aufbau größerer Linker-Einheiten, ohne Einbußen in dem Transfer elektrischer Ladung vom Dotanden auf den Lochleiter.

Ein weiterer erfindungsgemäßer Aspekt umfasst eine Ausgestaltung des Verfahrens, wobei der Lochleiter oder die Grundstruktur des organischen Lochleiters ohne funktionalisierendem Rest ausgesucht ist aus der Gruppe umfassend PEDOT (Poly(3,4-ethylendioxythiophen)), PVK (Poly(9-vinylcarbazol)), PTPD (Poly(N,N'-bis(4-butylphenyl)-N,N'-bis(phenyl)benzidin), PANI (Polyanilin), P3HT(Poly(3-hexylthiophen)) oder Mischungen daraus. Es hat sich gezeigt, dass diese Gruppe an Lochleitern sich relativ einfach mit hohen Umsätzen funktionalisieren lässt und durch das erfindungsgemäße Verfahren hoch leitfähige und chemisch sehr stabile Schichten erhältlich sind.

In einer zusätzlichen Verfahrenscharakteristik kann die vernetzte, lochleitende elektrische Schicht mittels eines Lösemittelprozesses hergestellt werden. Das erfindungsgemäße Verfahren überwindet insbesondere den Nachteil konventioneller Lösemittelverfahren, welche erfordern, dass Lösemittel nachfolgender Schichten komplementär zu dem Lösemittel schon abgeschiedener Schichten sein müssen. In den Standardverfahren ist diese Randbedingung einzuhalten, da ansonsten schon abgeschiedene Schichten wieder aufgelöst werden. Dies schränkt die Auswahl und die Prozessfähigkeit im hohen Maße ein, da für effiziente Bauteile sehr komplexe Schichtaufbauten benötigt werden. Diese Randbedingung entfällt im erfindungsgemäßen Verfahren, da durch die Vernetzungsreaktion chemisch und physikalisch "inerte" Schichten erhältlich sind und demzufolge in darauffolgenden Schichten mit beliebigen Lösungsmitteln gearbeitet werden kann, ohne dass die Gefahr besteht, dass darunterliegende Schichten wieder aufgelöst werden. Die Abstimmung des Lösemittels kann also rein auf die in der betreffenden Schicht abzuscheidenden Substanzen abgestimmt werden. Dies kann die Gleichmäßigkeit der Schichten deutlich erhöhen und die Verfahrensführung deutlich vereinfachen. Als Lösungsmittel kommen beispielsweise die in der DE 102012209523 für die Lösungsprozessierung erwähnten in Frage.

In einer zusätzlichen Verfahrenscharakteristik kann die vernetzte, lochleitende elektrische Schicht mittels eines Vakuumprozesses hergestellt werden. Dabei werden die funktionalisierten p-Dotanden und der Lochleiter oder die funktionalisierten p-Dotanden und der funktionalisierte Lochleiter im Vakuum verdampft und anschließend abgeschieden.

In einer Ausführungsform weist die vernetzte, lochleitende elektrische Schicht eine Schichtdicke zwischen 1 nm und 1000 nm, bevorzugt zwischen 30 nm und 300 nm, beispielsweise 200 nm, auf.

Des Weiteren erfindungsgemäß ist eine vernetzte lochleitende Schicht, welche nach dem hier beschriebenen, erfindungsgemäßen Verfahren erhältlich ist. Dies hier beschriebene Verfahren ist insbesondere geeignet, hoch homogene, vernetzte lochleitende Schichten bereitzustellen, welche nach den Standardverfahren der organischen Elektronik so nicht erhältlich sind.

Weiterhin sind im Sinne der Erfindung organisch, elektronische Bauelemente, aufweisend eine vernetzte, lochleitende elektrische Schicht, welche nach dem erfindungsgemäßen Verfahren hergestellt wurden oder herstellbar sind. Insbesondere in organisch elektrischen Bauelementen lassen sich die erfindungsgemäßen lochleitenden Schichten besonders vorteilhaft einsetzen. Zum einen ermöglicht die vorgestellte Prozessführung eine höchst effiziente und kostengünstige Herstellung und zum anderen werden durch die feste Anbindung des p-Dotanden an die Lochleiter besonders langlebige und lösungsmittelresistente p-leitfähige Schichten erhalten. Dies kann in einem hohen Maße zur Ausfallsicherheit und guten Weiterprozesszierbarkeit der so erhältlichen Bauelemente beitragen. Das beschriebene Verfahren und die damit herstellbaren vernetzten Schichten können entsprechend für Bauelemente wie Photodioden oder Solarzellen Verwendung finden. Insbesondere eignet sich das erfindungsgemäße Verfahren auch zur Herstellung bipolarer Transistoren. Das Verfahren ist mit den Standard-Herstellungsschritten dieser Bauelemente kompatibel und derart lassen sich kostengünstig, langlebige und effiziente Bauelemente erhalten.

Gemäß einer Ausführungsform ist das organische elektronische Bauelement aus einer Gruppe ausgewählt, die organische Transistoren, organische lichtemittierende Dioden, organische lichtemittierende elektrochemische Zellen, organische Solarzellen und organische Photodetektoren umfasst.

In einer Ausführungsform handelt es sich bei dem organischen Transistor um einen Feld-Effekt-Transistor oder einen bipolaren Transistor. Bipolare Transistoren sind beispielsweise in DE 10 2010 041 331 A1 näher beschrieben.

In einer Ausführungsform ist das organische elektronische Bauelement eine organische lichtemittierende Diode.

In einer Ausführungsform umfasst die organische lichtemittierende Diode eine lichtemittierende Schicht.

Im Hinblick auf den prinzipiellen Aufbau einer organischen lichtemittierenden Diode, dabei beispielsweise im Hinblick auf den Aufbau, die Schichtzusammensetzungen und die Materialien des Substrats, der Anode und der Kathode und der Verkapselungsanordnung, wird auf die Druckschrift WO 2010/066245 A1 verwiesen.

Hinsichtlich weiterer Vorteile und Merkmale der vorbeschriebenen organischen Bauelemente wird hiermit explizit auf die Erläuterungen im Zusammenhang mit den erfindungsgemäßen Schichten sowie dem erfindungsgemäßen Verfahren verwiesen. Auch sollen erfindungsgemäße Merkmale und Vorteile des erfindungsgemäßen Verfahrens auch für die erfindungsgemäßen Bauelemente und die erfindungsgemäßen Schichten anwendbar sein und als offenbart gelten und umgekehrt. Unter die Erfindung fallen auch sämtliche Kombinationen aus zumindest zwei von in der Beschreibung und/oder den Ansprüchen offenbarten Merkmalen, soweit nicht explizit ausgeschlossen.

Weitere Vorteile, vorteilhafte Ausführungsformen und Weiterbildungen ergeben sich aus den im Folgenden in Verbindung mit den Figuren beschriebenen Ausführungsbeispielen.
- Figur 1: zeigt eine schematische Seitenansicht eines Ausführungsbeispiels einer hier beschriebenen organischen lichtemittierenden Diode;
- Figur 2: zeigt eine schematische Seitenansicht eines Ausführungsbeispiels einer hier beschriebenen organischen Solarzelle;
- Figuren 3A bis 3F: zeigen schematische Seitenansichten von Ausführungsbeispielen eines hier beschriebenen organischen Feld-Effekt-Transistors.

In den Ausführungsbeispielen und Figuren können gleiche, gleichartige oder gleich wirkende Elemente jeweils mit denselben Bezugszeichen versehen sein. Die dargestellten Elemente und deren Größenverhältnisse untereinander sind nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben groß dargestellt sein.

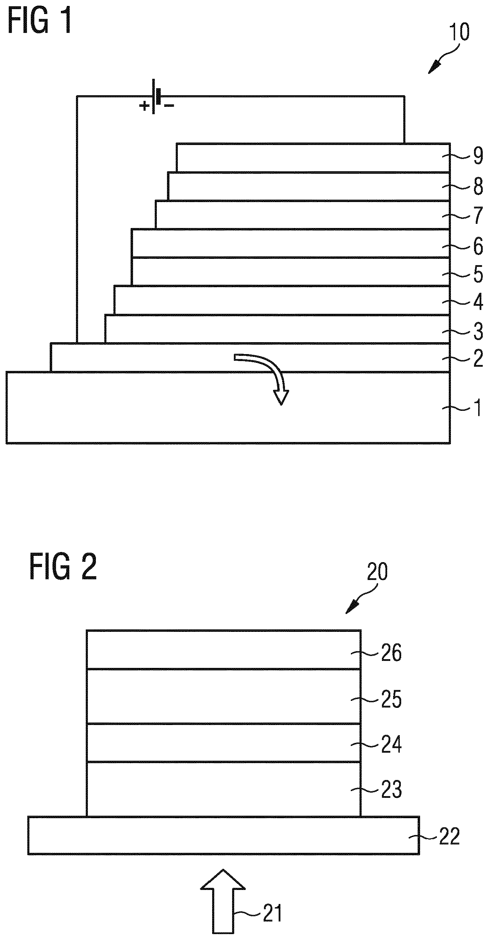

In Figur 1 ist ein Ausführungsbeispiel einer organischen lichtemittierenden Diode 10 gezeigt. Die organische lichtemittierende Diode 10 umfasst ein Substrat 1, beispielsweise aus Glas. Über dem Substrat 1 ist eine Anode 2 angeordnet, die aus Indiumzinnoxid, einem transparenten leitenden Oxid (transparent conductive oxide, TCO), gebildet ist. Über der Anode sind eine lochinjizierende Schicht 3, eine vernetzte, lochleitende elektrische Schicht 4 und eine lichtemittierende Schicht 5 angeordnet. Die vernetzte, lochleitende elektrische Schicht 4 kann beispielsweise aus einem Lochleiter, beispielsweise PEDOT, einer mit zwei Amingruppen funktionalisierten Verbindung als zusätzlicher Vernetzer und einem funktionalisierten p-Dotanden hergestellt sein (nicht Teil der beanspruchten Erfindung). Der funktionalisierte p-Dotand kann beispielsweise eine der folgenden Formeln aufweisen:

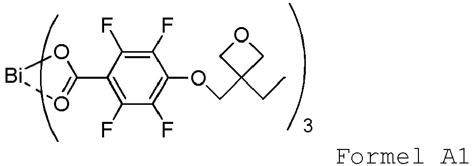

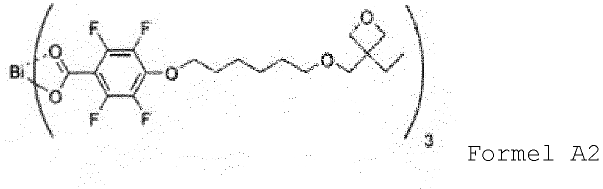

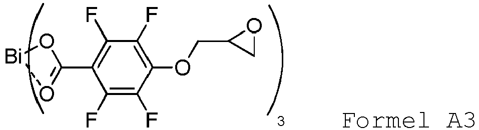

Die Vernetzung erfolgt über die funktionalisierten p-Dotanden mit dem zusätzlichen Vernetzer. Diese Vernetzung führt zu einer mechanisch sehr stabilen und chemisch inerten vernetzten lochleitenden elektrischen Schicht 4. Insbesondere wird die vernetzte lochleitende elektrische Schicht 4 mittels Lösungsprozessierung hergestellt.

Der p-Dotand liegt zu 20 Volumenprozent bezogen auf das Volumen des Lochleiters vor. Die vernetzte, lochleitende elektrische Schicht 4 weist eine Schichtdicke von 200 nm auf. Über der lichtemittierenden Schicht 5 ist eine lochblockierende Schicht 6, eine elektronentransportierende Schicht 7, eine elektroneninjizierende Schicht 8 und eine Kathode 9 aus Aluminium angeordnet. Die lichtemittierende Schicht 5 kann ein elektronen- und/oder lochtransportierendes Material und einen oder mehrere phosphoreszente oder fluoreszente Emitter enthalten. Materialien für die elektronentransportierende Schicht 7, die elektroneninjizierende Schicht 8 und die lochinjizierende Schicht 3 sind dem Fachmann bekannt. Beispielsweise ist die elektronentransportierende Schicht 7 aus 2-(4-Biphenylyl)-5-(4-tert-butylphenyl)-1,3,4-oxadiazol mit einem n-Dotierstoff NDN-1 oder Ca gebildet, die elektroneninjizierende Schicht 8 ist aus 2,9-Dimethyl-4,7-diphenyl-1,10-phenanthrolin (BCP) gebildet und die lochinjizierende Schicht 3 aus Poly(3,4-ethylendioxythiophen).

Zwischen der vernetzten, lochleitenden elektrischen Schicht 4 und der lichtemittierenden Schicht 5 kann eine elektronenblockierende Schicht angeordnet sein (hier nicht gezeigt). Materialien für die elektronenblockierende Schicht sind dem Fachmann bekannt. Beispielsweise kann Bis(2-methyl-8-quinolinolat)-4-(phenylphenolato)aluminium verwendet werden.

Der funktionalisierte p-Dotand der Formel A3 lässt sich beispielsweise durch folgende Synthese synthetisieren:

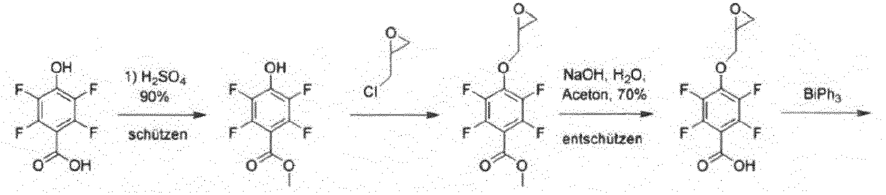

4-Hydroxy-2,3,5,6-tetra-Fluorbenzoesäure ist beispielsweise bei Fluorochem kommerziell erhältlich. In dieser Verbindung muss zunächst die Säuregruppe durch eine Veresterung vor einer Reaktion mit dem Epichorhydrin geschützt werden. Dies erfolgt durch Zugabe von Schwefelsäure. Anschließend erfolgt die Reaktion des 4-Hydroxy-2,3,5,6-tetra-Fluorbenzoesäuremethylesters mit Epichorhydrin, welches beispielsweise bei Sigma Aldrich kommerziell erhältlich ist.

Nach dem Entschützen der Säuregruppe erfolgt eine Umsetzung mit Triphenylbismuth zu dem funktionalisierten p-Dotanden.

Die Umsetzung mit Epichorhydrin ist für Methyl-4-hydroxy-benzoate mit anschließender Verseifung des Esters sowie für 4-Hydroxy-benzaldehyde mit anschließender Oxidation zur Carbonsäure in Cheedarala, Ravi Kumar; Sunkara, Vijaya; Park, Joon Won, Synthetic Communications, 2009, Vol. 39, 11, 1966-1980 und Obreza, A.; Perdith, F.; Journal of Structural Chemistry, 2012, Vol. 53, 4, 793-799, 7 beschrieben. Weiterhin ist diese Reaktion auch für Perfluorphenol mit Epichlorhydrin beschrieben in Solov'ev, D.V.; Kolomenskaya. L. V; Rodin, A.A.; Zenkevich, I. G; Lavrent'ev, A. N; J. Gen. Chem. UDSSR (Engl. Transl.) 1991, Vol. 61, 3.2, 673-678, 611-615.

Der funktionalisierte p-Dotand der Formel A1 lässt sich beispielsweise durch folgende Synthese synthetisieren:

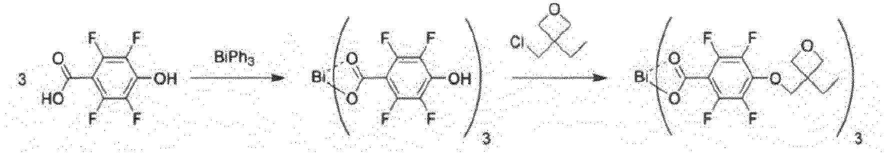

Zunächst erfolgt eine Umsetzung der 4-Hydroxy-2,3,5,6-tetra-Fluorbenzoesäure mit Triphenylbismuth. In einem zweiten Schritt erfolgt eine Umsetzung mit 3-Chloromethyl-3-ethyloxetan zum gewünschten funktionalisierten p-Dotanden der Formel A3.

Der funktionalisierte p-Dotand der Formel A2 lässt sich beispielsweise durch folgende Synthese synthetisieren:

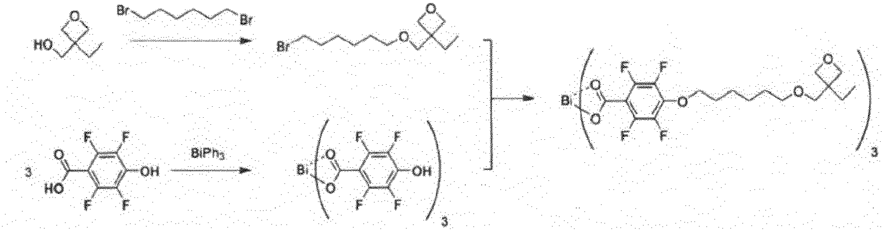

Zunächst wird 3-Ethyl-3-hydroxymethyl-oxetan mit 1,6-Dibromhexan äquimolar umgesetzt, um ein Brom zu substituieren. Nach einer gegebenenfalls erforderlichen chromatographischen Aufreinigung erfolgt eine Umsetzung mit dem aus 4-Hydroxy-2,3,5,6-tetra-Fluorbenzoesäure mit Triphenylbismuth hergestellten Bismuth-Komplex zur Bildung des funktionalisierten p-Dotanden der Formel A2.

Eine alternative Syntheseroute für den funktionalisierten p-Dotand der Formel A2 ist folgende:

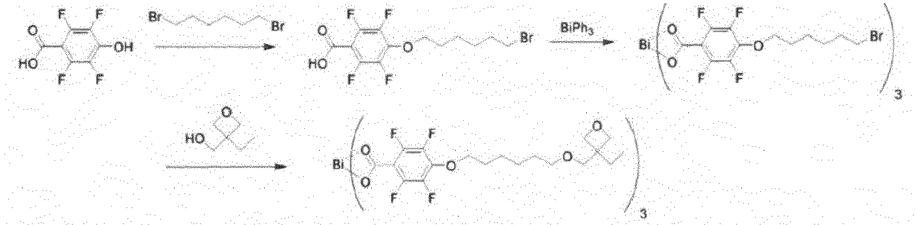

Zunächst erfolgt eine Umsetzung der 4-Hydroxy-2,3,5,6-tetra-Fluorbenzoesäure mit 1,6-Dibromhexan und in einem nächsten Schritt die Umsetzung mit Triphenylbismuth. In einem dritten Schritt erfolgt eine Umsetzung mit 3-Ethyl-3-hydroxymethyl-oxetan zum gewünschten funktionalisierten p-Dotanden der Formel A2.

Die eingesetzten Oxetane 3-Ethyl-3-hydroxymethyl-oxetan und 3-Chloromethyl-3-ethyloxetan können wie folgt hergestellt werden:

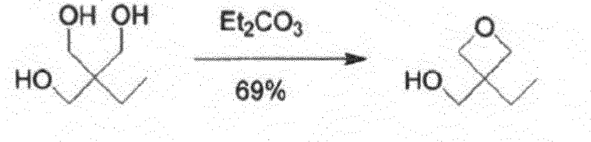

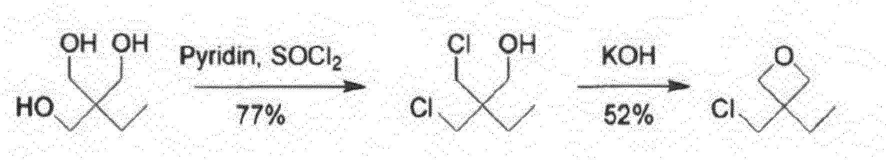

In Figur 2 ist ein Ausführungsbeispiel einer organischen Solarzelle mit PIN-Struktur 20 gezeigt, welche Licht 21 in elektrischen Strom umwandelt. Die Solarzelle 20 umfasst oder besteht aus einer Anode aus Indium-Zinn-Oxid 22, einer vernetzten, lochleitenden elektrischen Schicht 23, einer Absorptions-Schicht 24, einer dotierten elektronentransportierenden Schicht 25 und einer Kathode 26. Die vernetzte, lochleitende elektrische Schicht 23 weist eine Schichtdicke von 150 nm auf.

Die vernetzte, lochleitende elektrische Schicht 23 kann beispielsweise aus einem mit zwei primären Amingruppen funktionalisierten Lochleiter, beispielsweise PVK (Poly(9-vinylcarbazol)) und einem funktionalisierten p-Dotanden hergestellt sein. Der funktionalisierte p-Dotand kann beispielsweise folgende Formel aufweisen:

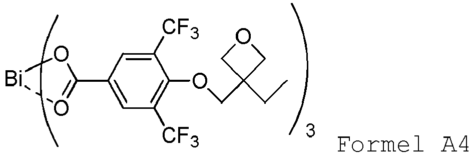

Die Vernetzung erfolgt durch eine Reaktion der funktionalisierten p-Dotanden mit dem funktionalisierten Lochleiter. Beispielsweise ist der Lochleiter mit zwei aromatischen sekundären Amingruppen funktionalisiert. Diese Vernetzung führt zu einer mechanisch sehr stabilen und chemisch inerten vernetzten lochleitenden elektrischen Schicht 23.

Der funktionalisierte p-Dotand liegt zu 15 Volumenprozent bezogen auf das Volumen des funktionalisierten Lochleiters vor. Die Materialien für die weiteren Schichten sind dem Fachmann bekannt. In der Absorptions-Schicht 24 wird Licht aus der Umgebung absorbiert. Durch die Aufnahme des Lichtes geht ein Molekül der Absorptionsschicht 24 in den angeregten Zustand über und es kommt zu einer Ladungstrennung Bei der Ladungstrennung bildet sich ein Exziton, also ein Elektronen-Loch-Paar. Diese ungleich geladenen Ladungen müssen nun voneinander getrennt werden. Dies ist insbesondere dann möglich, wenn das Elektron von einem starken Akzeptor aufgenommen wird und/oder das Loch von einem starken Donor aufgenommen wird. Ein solcher starker Akzeptor stellt die vernetzte, lochleitende elektrische Schicht 23 dar. Die vernetzte, lochleitende elektrische Schicht 23 wirkt sich positiv auf die Ladungsextraktion und somit auf die Effizienz von organischen Solarzellen aus.

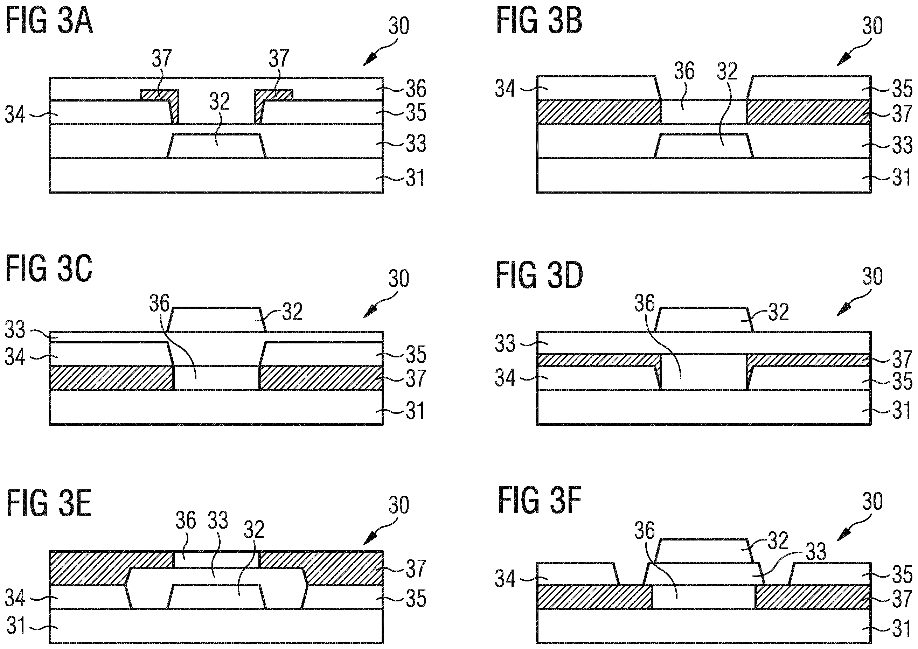

In den Figuren 3A bis 3F sind Ausführungsbeispiele von organischen Feld-Effekt-Transistoren 30 dargestellt. Auf einem Substrat 31 ist eine Gate-Elektrode 32, ein Gate-Dielektrikum 33, ein Source- und Drain-Kontakt 34 und 35 und eine organische Halbleiterschicht 36 aufgebracht. Die schraffierten Stellen 37 zeigen die erfindungsgemäße vernetzte, lochleitende elektrische Schicht. Alternativ kann auch die komplette Halbleiterschicht 36 als erfindungsgemäße vernetzte, lochleitende elektrische Schicht ausgeformt sein.

Die Erfindung ist nicht durch die Beschreibung anhand der Ausführungsbeispiele auf diese beschränkt.

### Bezugszeichenliste

- 1: Substrat
- 2: Anode
- 3: lochinjizierende Schicht
- 4: vernetzte, lochleitende elektrische Schicht
- 5: lichtemittierende Schicht
- 6: löcherblockierende Schicht
- 7: elektronentransportierende Schicht
- 8: elektroneninjizierende Schicht
- 9: Kathode
- 10: organische lichtemittierende Diode
- 20: organische Solarzelle mit PIN-Struktur
- 21: Licht
- 22: Anode
- 23: vernetzte, lochleitende elektrische Schicht
- 24: Absorptions-Schicht
- 25: dotierte elektronentransportierende Schicht
- 26: Kathode
- 30: organischer Feld-Effekt-Transistor
- 31: Substrat
- 32: Gate-Elektrode
- 33: Gate-Dielektrikum
- 34,35: Source- und Drain-Kontakt
- 36: organische Halbleiterschicht
- 37: vernetzte, lochleitende elektrische Schicht

## Patentansprüche

1. Verfahren zur Herstellung vernetzter, lochleitender elektrischer Schichten durch die Umsetzung funktionalisierter p-Dotanden, wobei die funktionalisierten p-Dotanden organische Metallkomplexe sind, die mindestens ein Zentralatom und organische Liganden umfassen, wobei das Zentralatom aus einem Metall der Gruppen 6-15 des Periodensystems ausgewählt ist und mindestens einer der organischen Liganden ausgewählt ist aus folgenden Formeln I-V: 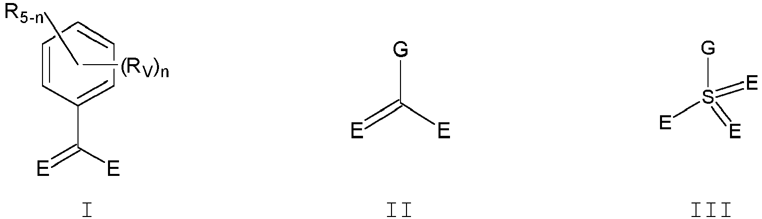 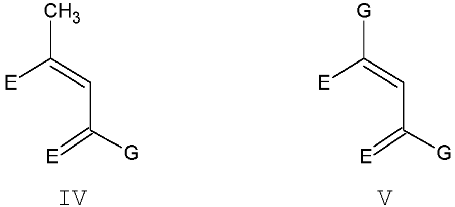 wobei
die E unabhängig voneinander Sauerstoff, Schwefel, Selen oder N(E₁)ₓ sind, wobei E₁ unabhängig voneinander ausgewählt ist aus der Gruppe umfassend H, D, substituiertes oder nicht substituiertes Alkyl oder Aryl und x = 0, 1 oder 2;
R unabhängig voneinander H, D, F, C1-C20 verzweigtes und unverzweigtes substituiertes oder nicht substituiertes Alkyl oder Aryl sind;
R_{V} jeweils unabhängig voneinander ausgewählt sind aus der Gruppe umfassend substituiertes oder nicht substituiertes Aryl, Alkyl, Alkoxy, Cycloalkyl, Arylene, Halogenaryl, Heteroaryl, Heteroarylene, Heterocycloalkylene, Heterocycloalkyl, Halogenheteroaryl, Alkenyl, Halogenalkenyl, Alkinyl, Halogenalkinyl, Ketoaryl, Halogenketoaryl, Ketoheteroaryl, Ketoalkyl, Halogenketoalkyl, Ketoalkenyl, Halogenketoalkenyl und
- jedes R_{V} jeweils mindestens einen funktionalisierenden Rest ausgewählt aus der Gruppe R_{F} umfassend -OH, -COOH, -NH₂, -NHR', Halogen, C2-C40-Alkenyl, -Dienyl, -Alkinyl, -Alkenyloxy, -Dienyloxy, -Alkinyloxy, Acrylsäure, Oxetan, Oxiran, Silan, Acrylsäure, Anhydrid und Cyclobutan aufweist oder aus diesen Resten besteht; wobei R' ein C1-C20 verzweigtes, unverzweigtes, substituiertes oder nicht substituiertes Alkyl oder Aryl ist;
- G=-C(R_{F})ᵤHᵥF_{w} mit u+v+w = 3;
- und n = 1 - 4, wobei die funktionalisierten p-Dotanden untereinander umgesetzt werden und vernetzen und die funktionalisierten p-Dotanden mit unterschiedlichen Resten R_{F} substituiert sind, wobei die einen p-Dotanden eine Epoxid- oder Oxetangruppe als R_{F} innerhalb von Rv oder G aufweisen und die anderen p-Dotanden eine NH₂-Gruppe oder eine NHR`-Gruppe als R_{F} innerhalb von Rᵥ oder G aufweisen, oder
wobei die funktionalisierten p-Dotanden mit funktionalisierten Lochleitern umgesetzt werden und die funktionalisierten Lochleiter ebenfalls mindestens einen Rest aus der Gruppe R_{F} oder R_{V} aufweisen, wobei die funktionalisierten p-Dotanden eine Epoxid- oder Oxetangruppe als R_{F} innerhalb von R_{V} oder G aufweisen und die funktionalisierten Lochleiter mindestens eine NH₂-Gruppe und/oder NHR`-Gruppe innerhalb der Gruppe R_{F} oder R_{V} aufweisen, oder
wobei die funktionalisierten p-Dotanden mit funktionalisierten Lochleitern umgesetzt werden und die funktionalisierten Lochleiter ebenfalls mindestens einen Rest aus der Gruppe R_{F} oder R_{V} aufweisen, wobei die funktionalisierten p-Dotanden eine NH₂-Gruppe und/oder NHR`-Gruppe als R_{F} innerhalb von R_{V} oder G aufweisen und die funktionalisierten Lochleiter eine Epoxid- oder Oxetangruppe innerhalb der Gruppe R_{F} oder R_{V} aufweisen.

2. Verfahren nach Anspruch 1,
wobei die funktionalisierten p-Dotanden untereinander umgesetzt werden und vernetzen.

3. Verfahren nach einem der vorhergehenden Ansprüche,
wobei die funktionalisierten p-Dotanden mit funktionalisierten Lochleitern umgesetzt werden und die funktionalisierten Lochleiter ebenfalls mindestens einen Rest aus der Gruppe R_{F} oder R_{V} aufweisen und wobei die funktionalisierten p-Dotanden mit den funktionalisierten Lochleitern vernetzen.

4. Verfahren nach einem der vorhergehenden Ansprüche,
wobei der Metallkomplex als Zentralatom Bismut, Zinn, Zink, Rhodium, Molybdän, Chrom oder Kupfer umfasst und mindestens einer der organischen Liganden der Formel I entspricht.

5. Verfahren nach einem der vorhergehenden Ansprüche,
wobei mindestens einer der organischen Liganden einer der folgenden Formeln VI, VII oder VIII entspricht 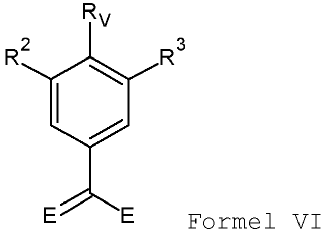 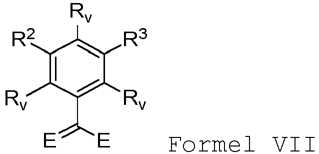 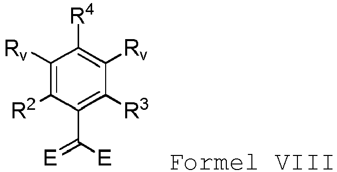 wobei
R² und R³ oder R², R³ und R⁴ unabhängig voneinander ausgewählt sind aus F und verzweigtem und unverzweigtem substituiertem Alkyl oder substituiertem Aryl, und wobei R_{V} jeweils unabhängig voneinander ausgewählt sind aus der Gruppe umfassend substituiertes oder nicht substituiertes Aryl, Alkyl, Alkoxy, Cycloalkyl, Arylene, Halogenaryl, Heteroaryl, Heteroarylene, Heterocycloalkylene, Heterocycloalkyl, Halogenheteroaryl, Alkenyl, Halogenalkenyl, Alkinyl, Halogenalkinyl, Ketoaryl, Halogenketoaryl, Ketoheteroaryl, Ketoalkyl, Halogenketoalkyl, Ketoalkenyl, Halogenketoalkenyl und
- jedes R_{V} jeweils mindestens einen funktionalisierenden Rest ausgewählt aus der Gruppe R_{F} umfassend -OH, -COOH, -NH₂, -NHR', Halogen, C2-C40-Alkenyl, -Dienyl, -Alkinyl, -Alkenyloxy, -Dienyloxy, -Alkinyloxy, Acrylsäure, Oxetan, Oxiran, Silan, Acrylsäure, Anhydrid und Cyclobutan aufweist oder aus diesen Resten besteht; wobei R' ein C1-C20 verzweigtes, unverzweigtes, substituiertes oder nicht substituiertes Alkyl oder Aryl ist.

6. Verfahren nach einem der Ansprüche 1 bis 3,
wobei der Metallkomplex Bismut, Zinn, Zink, Rhodium, Molybdän, Chrom oder Kupfer umfasst und mindestens einer der organischen Liganden der Formel II entspricht.

7. Verfahren nach einem der Ansprüche 1 bis 3,
wobei der Metallkomplex Bismut, Zinn, Zink, Rhodium, Molybdän, Chrom oder Kupfer umfasst und mindestens einer der organischen Liganden der Formel III entspricht.

8. Verfahren nach einem der Ansprüche 1 bis 3,
wobei der Metallkomplex Bismut, Zinn, Zink, Rhodium, Molybdän, Chrom oder Kupfer umfasst und mindestens einer der organischen Liganden der Formel IV entspricht.

9. Verfahren nach einem der Ansprüche 1 bis 3,
wobei der Metallkomplex Bismut, Zinn, Zink, Rhodium, Molybdän, Chrom oder Kupfer umfasst und mindestens einer der organischen Liganden der Formel V entspricht.

10. Verfahren nach einem der vorhergehenden Ansprüche,
wobei die Reste R² und R³, R², R³ und R⁴ oder G jeweils mindestens einfach fluoriert sind.

11. Verfahren nach einem der vorhergehenden Ansprüche,
wobei R_{F} oder R_{V} die Reste Q1a bis Q29 umfassen oder aus den Resten Q1a bis Q29 bestehen 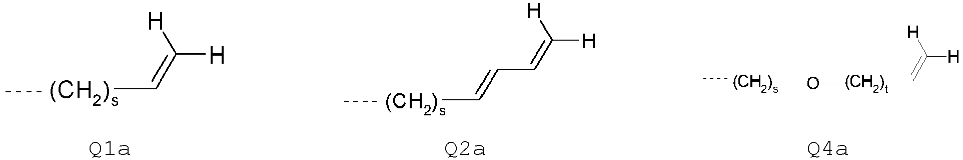 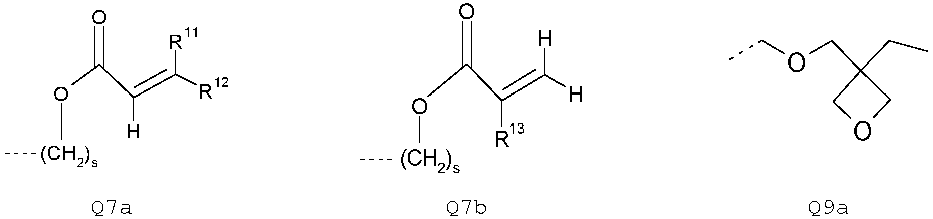 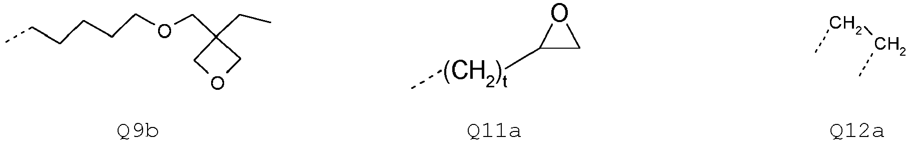 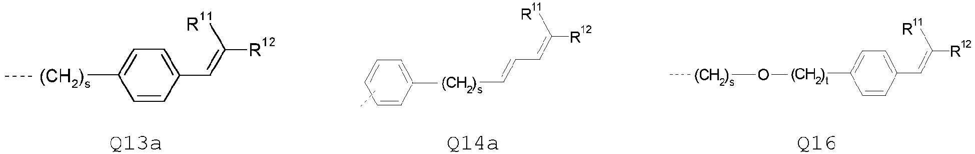 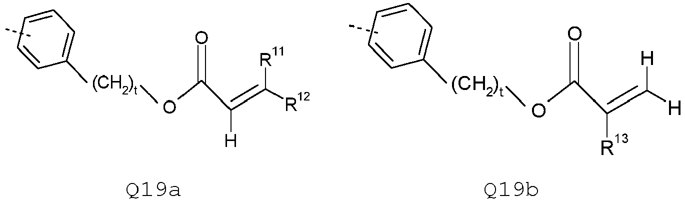 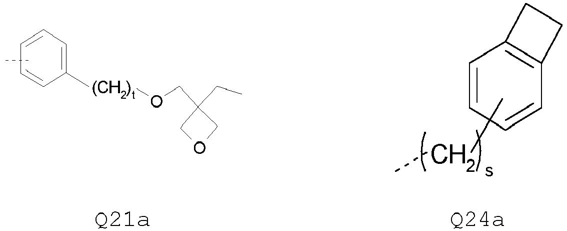 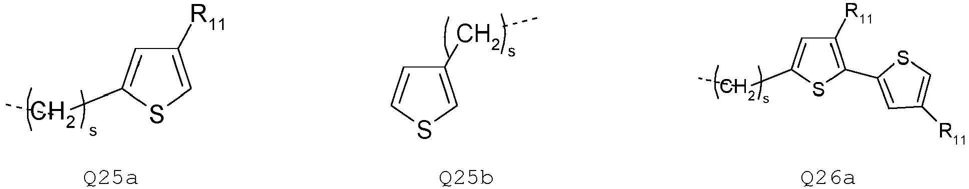 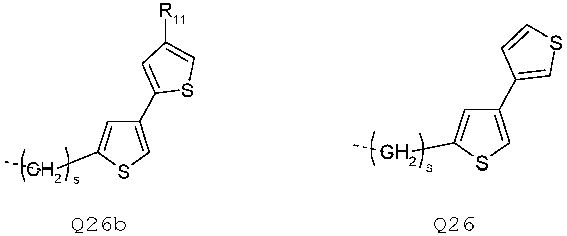 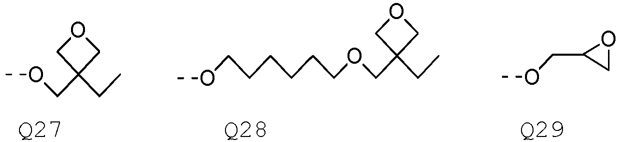 wobei die Reste
R¹¹ und R¹² gleich oder verschieden sein können und ausgewählt sind aus der Gruppe umfassend H, D oder ein geradkettiges oder verzweigtes C1-C6 Alkyl,
R¹³ ein geradkettiges oder verzweigtes C1-C6 Alkyl ist, s = 0 bis 8 ist und
t = 1 bis 8 beträgt.

12. Verfahren nach einem der vorhergehenden Ansprüche, wobei R_{F} oder R_{V} die Reste Q1a bis Q29 umfassen oder aus den Resten Q1b bis Q26g bestehen

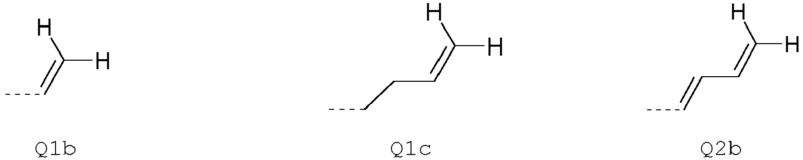

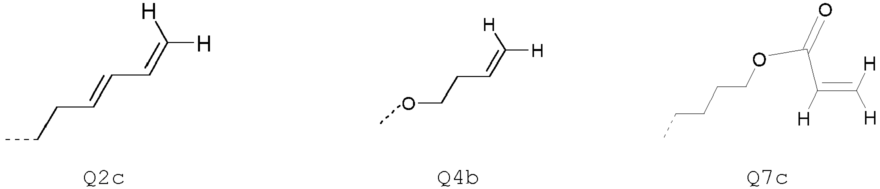

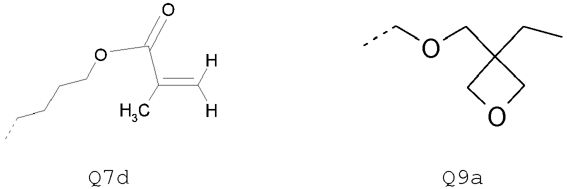

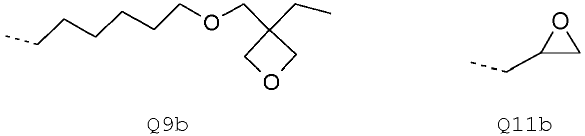

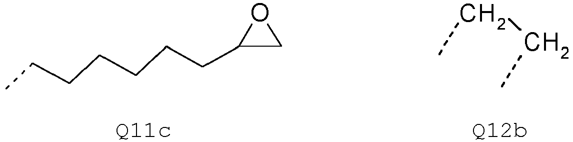

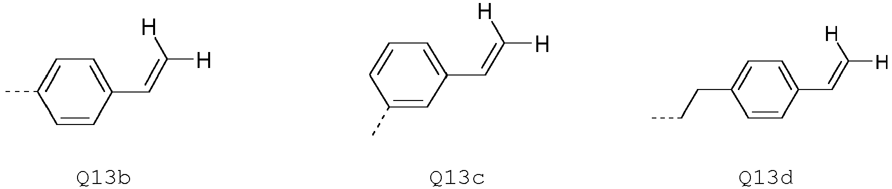

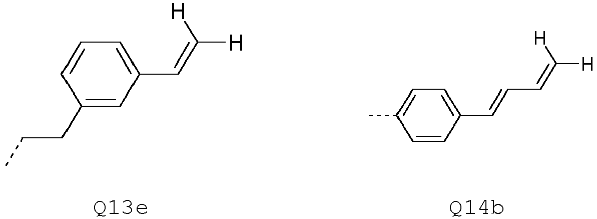

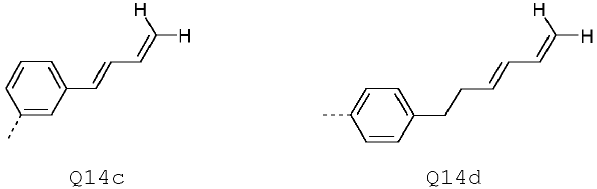

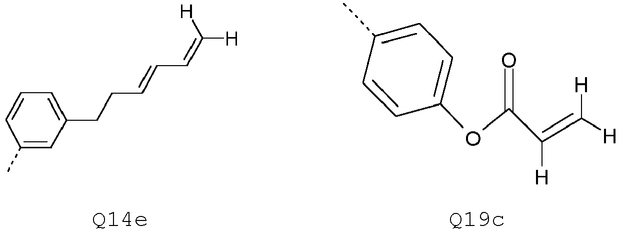

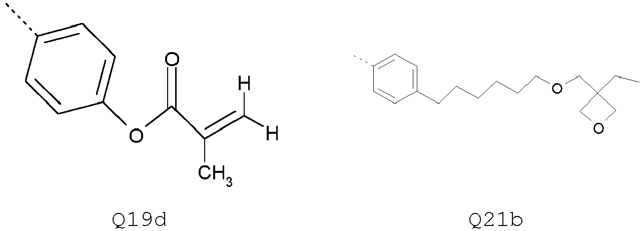

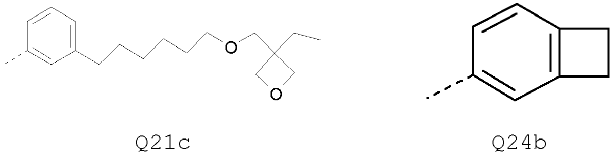

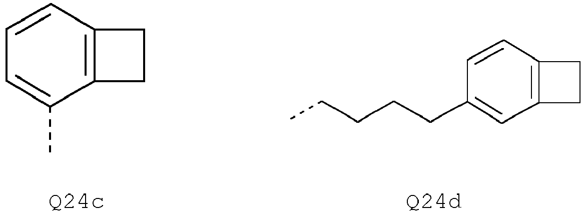

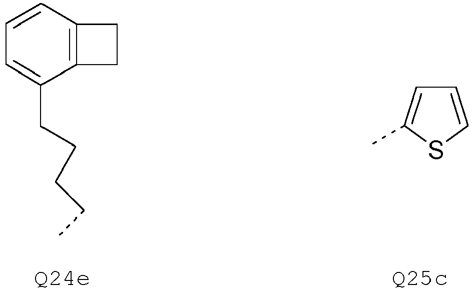

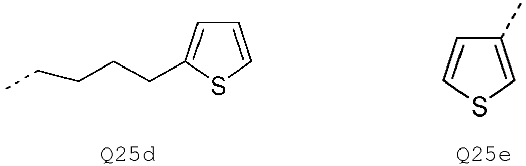

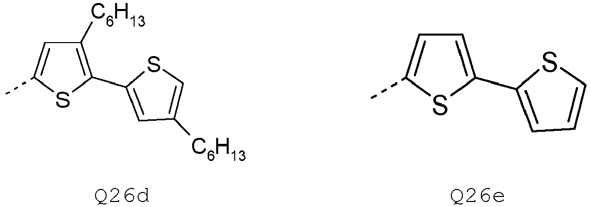

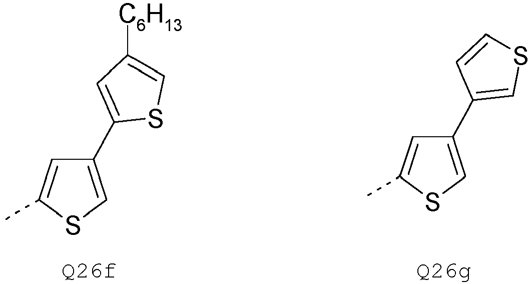

13. Verfahren nach einem der vorhergehenden Ansprüche, wobei zwischen dem mindestens einen organischen Liganden und R_{F} oder dem Lochleiter und R_{F} ein zusätzlicher Linker angeordnet ist, wobei der Linker ausgewählt ist aus der Gruppe umfassend fluoriertes oder nicht fluoriertes C1-C20 Alkyl, Alkenyl, Alkinyl, Polyethylenglykol, Polyethylendiamin, Polyester, Polyurethan, Polyvinylidenphenylen oder Gemischen daraus.

14. Verfahren nach Anspruch 13,
wobei die Einheit aus funktionalisierendem Rest R_{F} und Linker, insbesondere R_{V}, ausgesucht ist aus der Gruppe umfassend Q13 - Q26 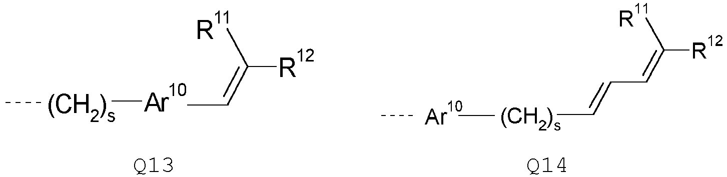 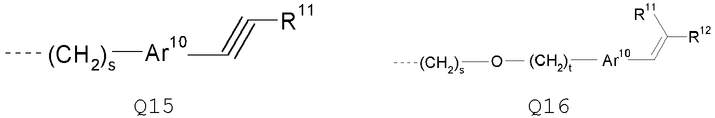 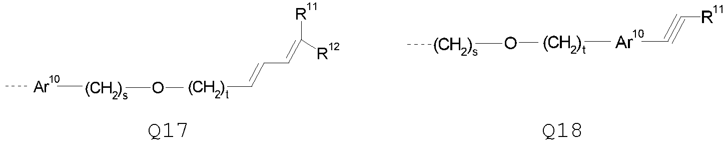 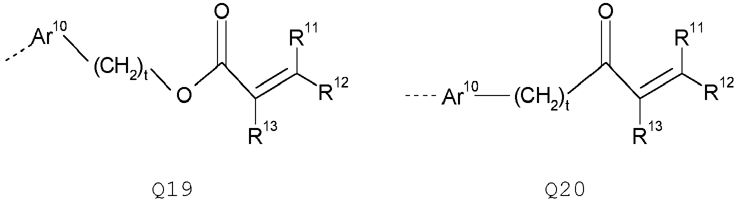 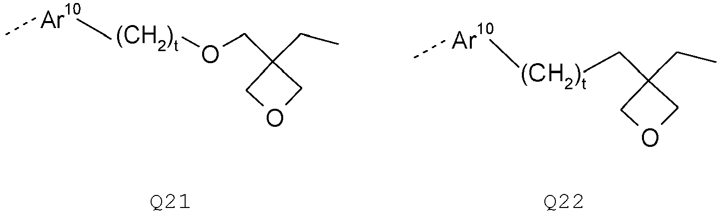 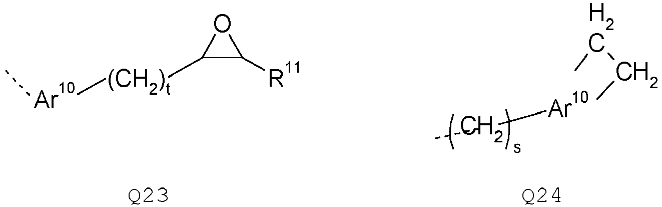 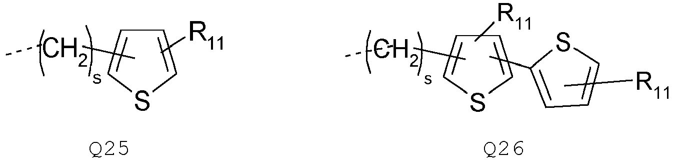
wobei Ar¹⁰ ein mono- oder polycyclisches, aromatisches oder heteroaromatisches C5-C60 Ringsystem ist wobei die Reste
R¹¹ und R¹² gleich oder verschieden sein können und ausgewählt sind aus der Gruppe umfassend H, D oder ein geradkettiges oder verzweigtes C1-C6 Alkyl,
R¹³ ein geradkettiges oder verzweigtes C1-C6 Alkyl ist, s = 0 bis 8 ist und
t = 1 bis 8 beträgt.

15. Vernetzte, lochleitende elektrische Schicht, erhältlich nach einem Verfahren nach einem der Ansprüche 1-14.

16. Organisch, elektronisches Bauelement, aufweisend eine vernetzte, lochleitende elektrische Schicht nach Anspruch 15.

## Claims

1. Process for the production of crosslinked, hole-conducting electrical layers by the reaction of functionalised p-dopants, where the functionalised p-dopants are organic metal complexes which comprise at least one central atom and organic ligands, where the central atom is selected from a metal from groups 6-15 of the Periodic Table and at least one of the organic ligands is selected from the following formulae I-V: 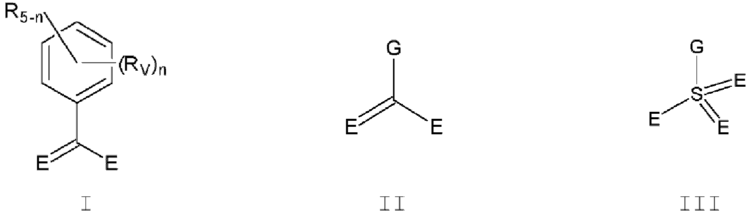 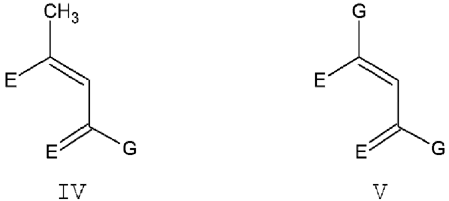 where
the E are, independently of one another, oxygen, sulfur, selenium or N(E₁)ₓ, where E₁ is selected, independently of one another, from the group comprising H, D, substituted or unsubstituted alkyl or aryl and x = 0, 1 or 2;
R are, independently of one another, H, D, F, C1-C20 branched or unbranched substituted or unsubstituted alkyl or aryl;
R_{V} are in each case selected, independently of one another, from the group comprising substituted or unsubstituted aryl, alkyl, alkoxy, cycloalkyl, arylene, haloaryl, heteroaryl, heteroarylene, heterocycloalkylene, heterocycloalkyl, haloheteroaryl, alkenyl, haloalkenyl, alkynyl, haloalkynyl, ketoaryl, haloketoaryl, ketoheteroaryl, ketoalkyl, haloketoalkyl, ketoalkenyl, haloketoalkenyl and - each R_{V} in each case has at least one functionalising radical selected from the group R_{F} comprising -OH, -COOH, -NH₂, -NHR', halogen, C2-C40-alkenyl, -dienyl, -alkynyl, -alkenyloxy, -dienyloxy, -alkynyloxy, acrylic acid, oxetane, oxirane, silane, acrylic acid anhydride and cyclobutane or consists of these radicals; where R` is a C1-C20 branched, unbranched, substituted or unsubstituted alkyl or aryl;
- G=-C(R_{F})ᵤHᵥF_{w} where u+v+w = 3;
- and n = 1 - 4, where the functionalised p-dopants are reacted with one another and crosslink and the functionalised p-dopants are substituted by different radicals R_{F}, where some p-dopants have an epoxide or oxetane group as R_{F} within R_{V} or G and the other p-dopants have an NH₂ group or an NHR` group as R_{F} within R_{V} or G, or
where the functionalised p-dopants are reacted with functionalised hole conductors and the functionalised hole conductors likewise have at least one radical from the group R_{F} or R_{V}, where the functionalised p-dopants have an epoxide or oxetane group as R_{F} within R_{V} or G and the functionalised hole conductors have at least one NH₂ group and/or NHR` group within the group R_{F} or R_{V}, or
where the functionalised p-dopants are reacted with functionalised hole conductors and the functionalised hole conductors likewise have at least one radical from the group R_{F} or R_{V}, where the functionalised p-dopants have an NH₂ group and/or NHR` group as R_{F} within R_{V} or G and the functionalised hole conductors have an epoxide or oxetane group within the group R_{F} or R_{V}.

2. Process according to Claim 1,
where the functionalised p-dopants are reacted with one another and crosslink.

3. Process according to one of the preceding claims, where the functionalised p-dopants are reacted with functionalised hole conductors and the functionalised hole conductors likewise have at least one radical from the group R_{F} or R_{V} and where the functionalised p-dopants crosslink with the functionalised hole conductors.

4. Process according to one of the preceding claims, where the metal complex comprises, as central atom, bismuth, tin, zinc, rhodium, molybdenum, chromium or copper and corresponds to at least one of the organic ligands of the formula I.

5. Process according to one of the preceding claims, where at least one of the organic ligands corresponds to one of the following formulae VI, VII or VIII 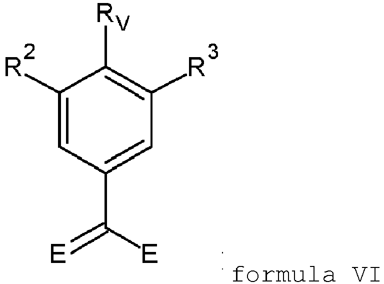 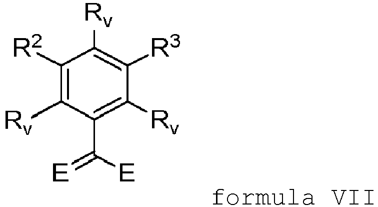 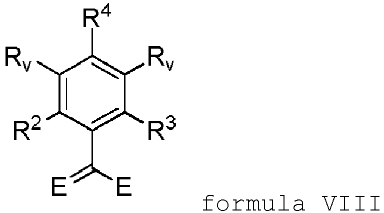 where
R² and R³ or R², R³ and R⁴ are selected, independently of one another, from F and branched or unbranched substituted alkyl or substituted aryl, and where R_{V} are in each case selected, independently of one another, from the group comprising substituted or unsubstituted aryl, alkyl, alkoxy, cyoloalkyl, arylene, haloaryl, heteroaryl, heteroarylene, heterocycloalkylene, heterocycloalkyl, haloheteroaryl, alkenyl, haloalkenyl, alkynyl, haloalkynyl, ketoaryl, haloketoaryl, ketoheteroaryl, ketoalkyl, haloketoalkyl, ketoalkenyl, haloketoalkenyl and - each R_{V} in each case has at least one functionalising radical selected from the group R_{F} comprising -OH, -COOH, -NH₂, -NHR', halogen, C2-C40-alkenyl, -dienyl, -alkynyl, -alkenyloxy, -dienyloxy, -alkynyloxy, acrylic acid, oxetane, oxirane, silane, acrylic acid anhydride and cyclobutane or consists of these radicals; where R' is a C1-C20 branched, unbranched, substituted or unsubstituted alkyl or aryl.

6. Process according to one of Claims 1 to 3,
where the metal complex comprises bismuth, tin, zinc, rhodium, molybdenum, chromium or copper and corresponds to at least one of the organic ligands of the formula II.

7. Process according to one of Claims 1 to 3,
where the metal complex comprises bismuth, tin, zinc, rhodium, molybdenum, chromium or copper and corresponds to at least one of the organic ligands of the formula III.

8. Process according to one of Claims 1 to 3,
where the metal complex comprises bismuth, tin, zinc, rhodium, molybdenum, chromium or copper and corresponds to at least one of the organic ligands of the formula IV.

9. Process according to one of Claims 1 to 3,
where the metal complex comprises bismuth, tin, zinc, rhodium, molybdenum, chromium or copper and corresponds to at least one of the organic ligands of the formula V.

10. Process according to one of the preceding claims, where the radicals R² and R3, R², R³ and R⁴ or G are in each case at least monofluorinated.

11. Process according to one of the preceding claims, where R_{F} or R_{V} comprise the radicals Q1a to Q29 or consist of the radicals Q1a to Q29 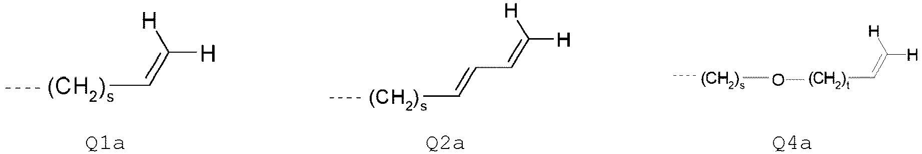 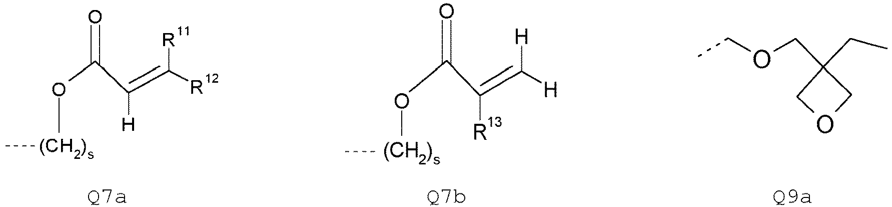 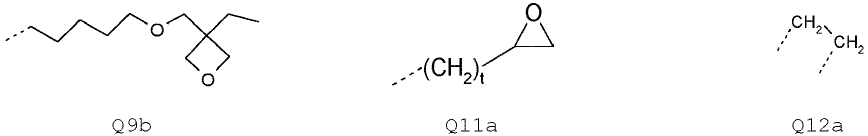 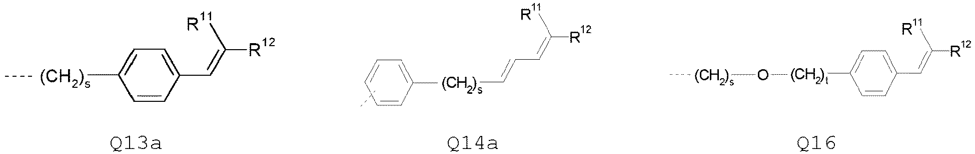 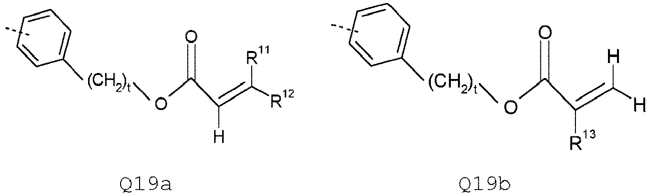 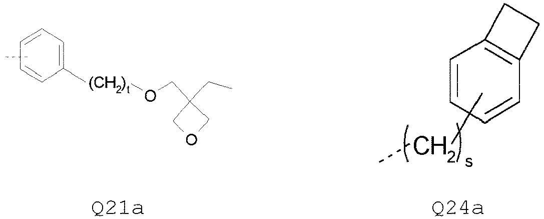 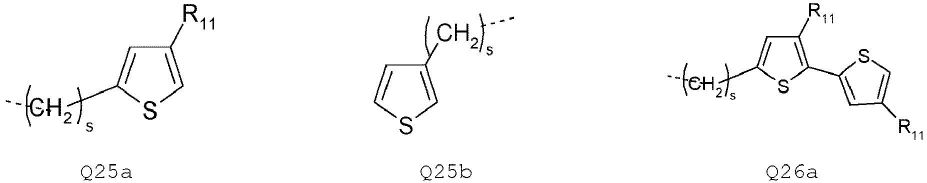 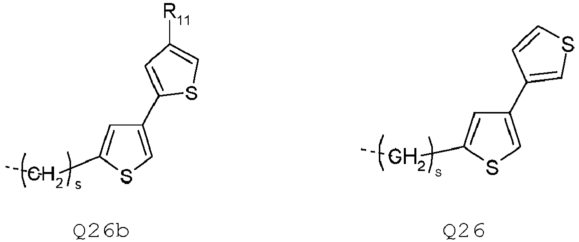 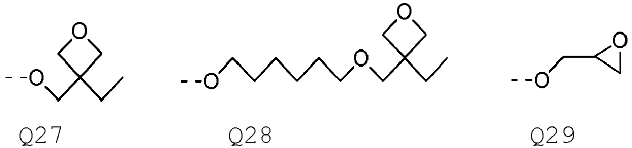 where the radicals
R¹¹ and R¹² may be identical or different and are selected from the group comprising H, D or a straight-chain or branched Cl-C6 alkyl,
R¹³ is a straight-chain or branched C1-C6 alkyl, s = 0 to 8 and
t = 1 to 8.

12. Process according to one of the preceding claims, where R_{F} or R_{V} comprise the radicals Q1b to Q26g or consist of the radicals Q1b to Q26g

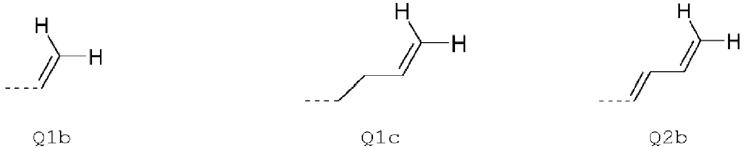

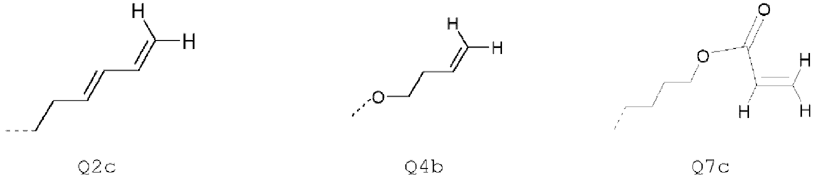

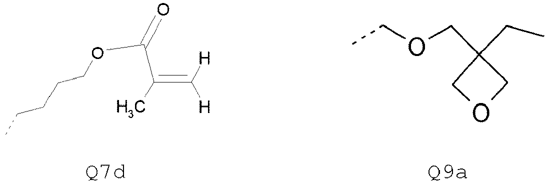

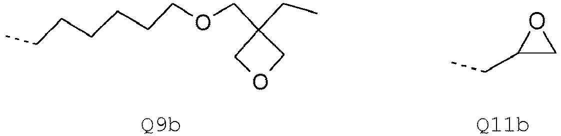

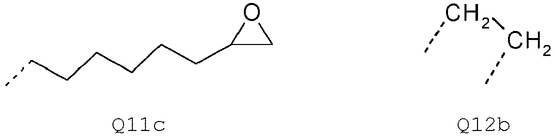

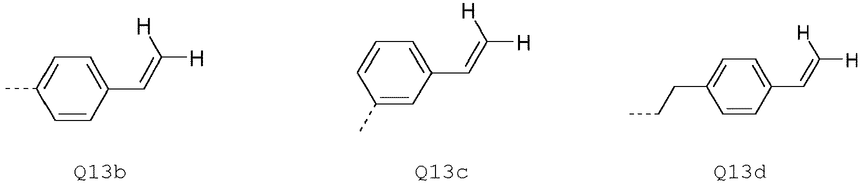

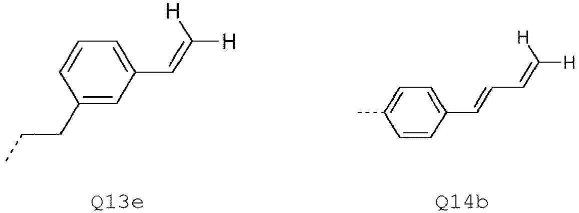

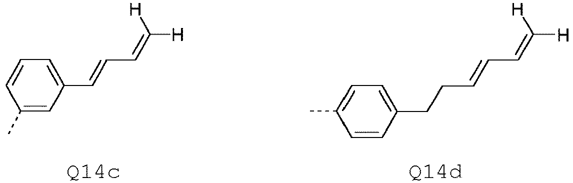

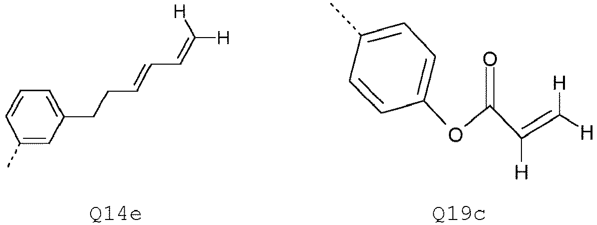

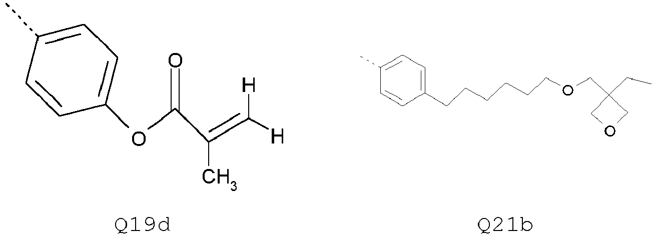

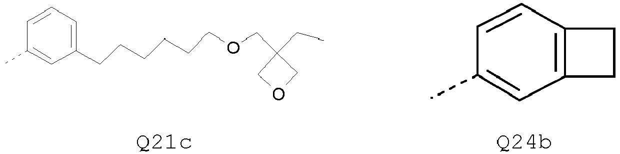

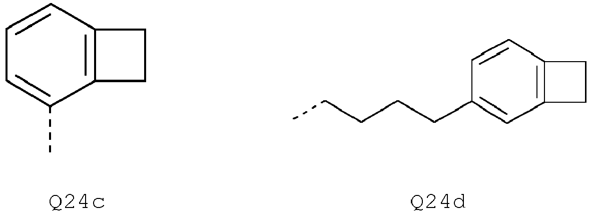

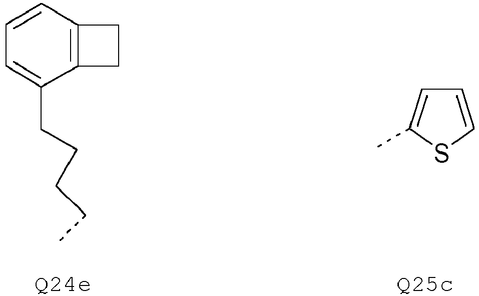

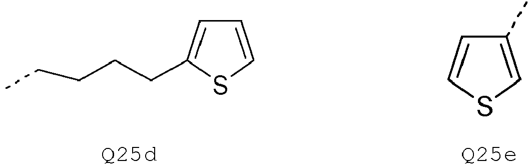

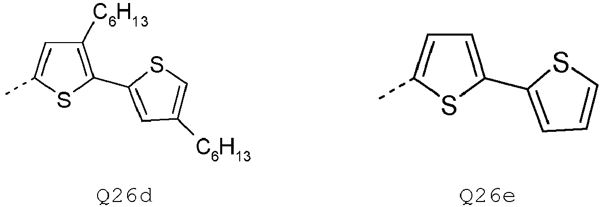

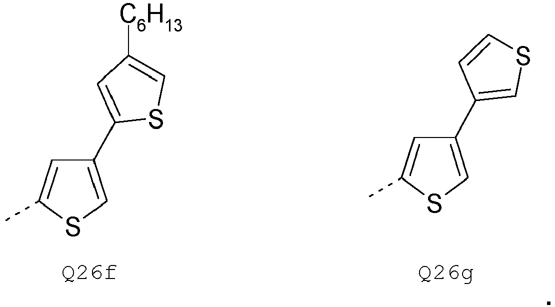

13. Process according to one of the preceding claims, where an additional linker is arranged between the at least one organic ligand and R_{F} or the hole conductor and R_{F}, where the linker is selected from the group comprising fluorinated or unfluorinated C1-C20 alkyl, alkenyl, alkynyl, polyethylene glycol, polyethylenediamine, polyester, polyurethane, polyvinylidenephenylene or mixtures thereof.

14. Process according to Claim 13,
where the unit comprising functionalising radical R_{F} and linker, in particular R_{V}, is chosen from the group comprising Q13 - Q26 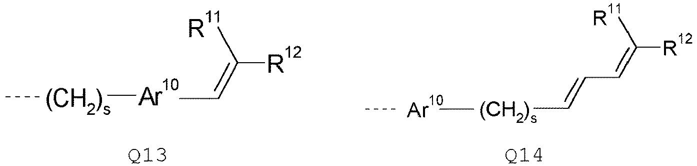 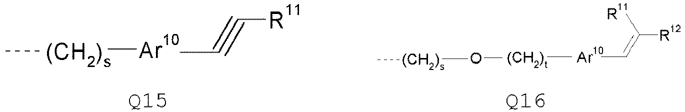 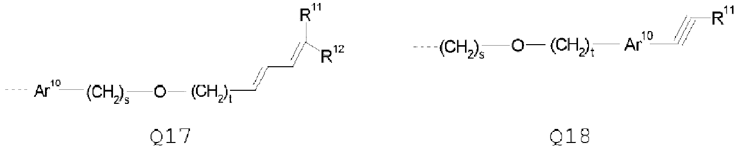 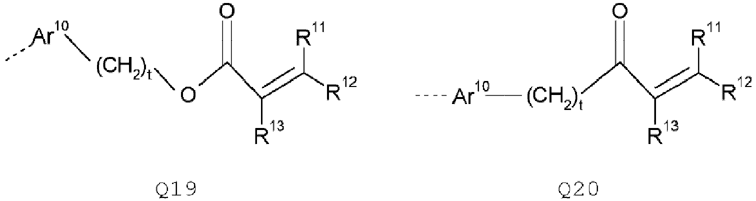 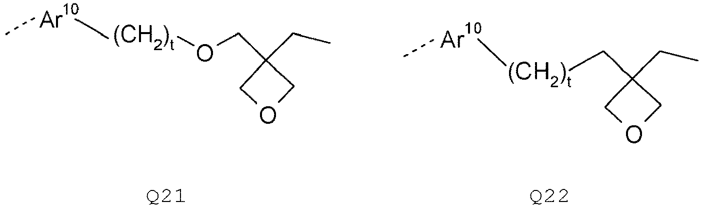 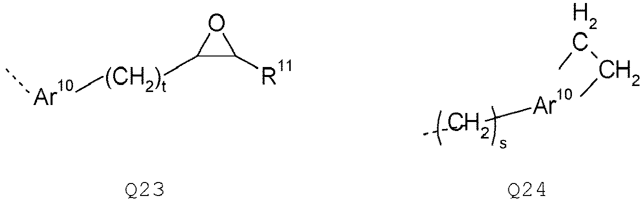 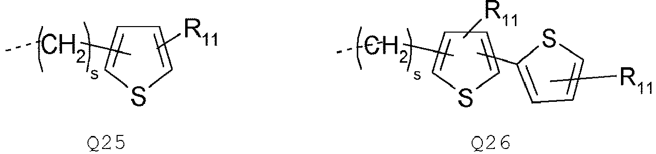
where Ar¹⁰ is a mono- or polycyclic, aromatic or heteroaromatic C5-C60 ring system,
where the radicals
R¹¹ and R¹² may be identical or different and are selected from the group comprising H, D or a straight-chain or branched C1-C6 alkyl,
R¹³ is a straight-chain or branched C1-C6 alkyl, s = 0 to 8 and
t = 1 to 8.

15. Crosslinked, hole-conducting electrical layer, obtainable by a process according to one of Claims 1-14.

16. Organic, electronic component, having a crosslinked, hole-conducting electrical layer according to Claim 15.

## Revendications

1. Procédé de production de couches électriques réticulées de transport de trous par la réaction de dopants de type P fonctionnalisés, dans lequel les dopants de type P fonctionnalisés sont des complexes métalliques organiques comprenant au moins un atome central et des ligands organiques, où l'atome central est choisi parmi un métal issu des groupes 6-15 du Tableau Périodique et au moins l'un parmi les ligands organiques est choisi parmi les formules I-V suivantes : 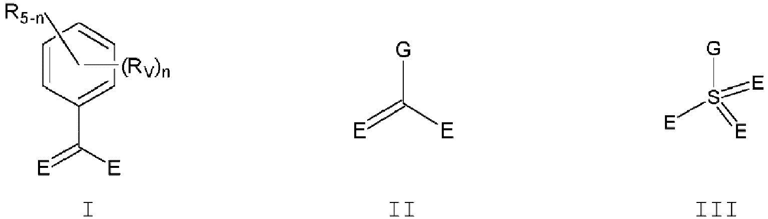 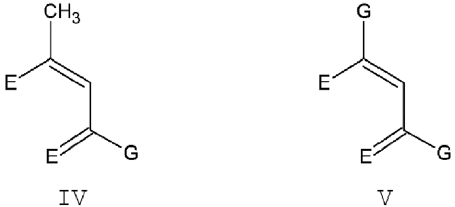 dans lesquelles
E sont, indépendamment les uns des autres, oxygène, soufre, sélénium ou N(E₁)ₓ, où E₁ est choisi, indépendamment les uns des autres, dans le groupe comprenant H, D, alkyle ou aryle substitué ou non substitué et x = 0, 1 ou 2 ;
R sont, indépendamment les uns des autres, H, D, F, C1-C20 alkyle ou aryle substitué ou non substitué, ramifié ou non ramifié ;
R_{V} sont choisis dans chaque cas, indépendamment les uns des autres, dans le groupe comprenant aryle, alkyle, alcoxy, cycloalkyle, arylène, halo-génoaryle, hétéroaryle, hétéroarylène, hétéro-cycloalkylène, hétérocycloalkyle, halogénohétéroaryle, alcényle, halogénoalcényle, alcynyle, halogénoalcynyle, cétoaryle, halogénocétoaryle, cétohétéroaryle, cétoalkyle, halogénocétoalkyle, cétoalcényle, halogénocétoalcényle substitué ou non substitué et
- chaque R_{V} dans chaque cas possède au moins un radical fonctionnalisant choisi parmi le groupement R_{F} comprenant -OH, -COOH, -NH₂, -NHR', halogène, C2-C40-alcényle, -diényle, -alcynyle, -alcényloxy, -diényloxy, -alcynyloxy, acide acrylique, oxétane, oxirane, silane, anhydride d'acide acrylique et cyclobutane ou est constitué de ces radicaux ; où R' est un groupement C1-C20 alkyle ou aryle substitué ou non substitué, ramifié, non ramifié ;
- G=-C(R_{F})ᵤHᵥF_{w} où u+v+w = 3 ;
- et n = 1 - 4, où les dopants de type P fonctionnalisés sont réagis les uns avec les autres et se réticulent et les dopants de type P fonctionnalisés sont substitués par différents radicaux R_{F}, où certains dopants de type P possèdent un groupement époxyde ou oxétane en tant que R_{F} au sein de R_{V} ou G et les autres dopants de type P possèdent un groupement NH₂ ou un groupement NHR` en tant que R_{F} au sein de R_{V} ou G, ou
où les dopants de type P fonctionnalisés sont réagis avec des transporteurs de trous fonctionnalisés et les transporteurs de trous fonctionnalisés possèdent de même au moins un radical issu du groupement R_{F} ou R_{V}, où les dopants de type P fonctionnalisés possèdent un groupement époxyde ou oxétane en tant que R_{F} au sein de R_{V} ou G et les transporteurs de trous fonctionnalisés possèdent au moins un groupement NH₂ et/ou groupement NHR' au sein du groupement R_{F} ou R_{V}, ou
où les dopants de type P fonctionnalisés sont réagis avec des transporteurs de trous fonctionnalisés et les transporteurs de trous fonctionnalisés possèdent de même au moins un radical issu du groupement R_{F} ou R_{V}, où les dopants de type P fonctionnalisés possèdent un groupement NH₂ et/ou groupement NHR` en tant que R_{F} au sein de R_{V} ou G et les transporteurs de trous fonctionnalisés possèdent un groupement époxyde ou oxétane au sein du groupement R_{F} ou R_{V}.

2. Procédé selon la revendication 1,
où les dopants de type P fonctionnalisés sont réagis les uns avec les autres et se réticulent.

3. Procédé selon l'une des revendications précédentes,
où les dopants de type P fonctionnalisés sont réagis avec des transporteurs de trous fonctionnalisés et les transporteurs de trous fonctionnalisés possèdent de même au moins un radical issu du groupement R_{F} ou R_{V} et où les dopants de type P fonctionnalisés se réticulent avec les transporteurs de trous fonctionnalisés.

4. Procédé selon l'une des revendications précédentes,
dans lequel le complexe métallique comprend, comme atome central, du bismuth, de l'étain, du zinc, du rhodium, du molybdène, du chrome ou du cuivre et correspond à au moins l'un parmi les ligands organiques de formule I.

5. Procédé selon l'une des revendications précédentes,
dans lequel au moins l'un parmi les ligands organiques correspond à l'une parmi les formules VI, VII ou VIII suivantes 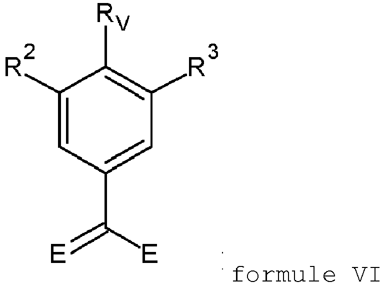 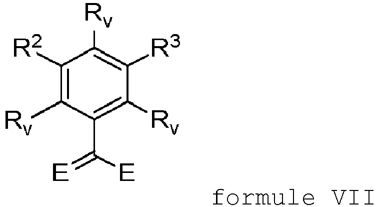 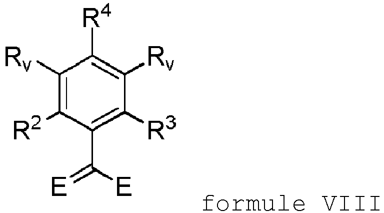
dans lesquelles
R² et R³ ou R², R³ et R⁴ sont choisis, indépendamment les uns des autres, parmi F et alkyle substitué, ramifié ou non ramifié, ou aryle substitué, et où R_{V} sont choisis dans chaque cas, indépendamment les uns des autres, dans le groupe comprenant aryle, alkyle, alcoxy, cycloalkyle, arylène, halogénoaryle, hétéroaryle, hétéroarylène, hétérocycloalkylène, hétérocycloalkyle, halogénohétéroaryle, alcényle, halogénoalcényle, alcynyle, halogénoalcynyle, cétoaryle, halogénocétoaryle, cétohétéroaryle, cétoalkyle, halogénocétoalkyle, cétoalcényle, halogénocétoalcényle substitué ou non substitué et
- chaque R_{V} dans chaque cas possède au moins un radical fonctionnalisant choisi parmi le groupement R_{F} comprenant -OH, -COOH, -NH₂, -NHR`, halogène, C2-C40-alcényle, -diényle, -alcynyle, -alcényloxy, -diényloxy, -alcynyloxy, acide acrylique, oxétane, oxirane, silane, anhydride d'acide acrylique et cyclobutane ou est constitué de ces radicaux ; où R' est C1-C20 alkyle ou aryle substitué ou non substitué, ramifié, non ramifié.

6. Procédé selon l'une des revendications 1 à 3, dans lequel le complexe métallique comprend du bismuth, de l'étain, du zinc, du rhodium, du molybdène, du chrome ou du cuivre et correspond à au moins l'un parmi les ligands organiques de formule II.

7. Procédé selon l'une des revendications 1 à 3, dans lequel le complexe métallique comprend du bismuth, de l'étain, du zinc, du rhodium, du molybdène, du chrome ou du cuivre et correspond à au moins l'un parmi les ligands organiques de formule III.

8. Procédé selon l'une des revendications 1 à 3, dans lequel le complexe métallique comprend du bismuth, de l'étain, du zinc, du rhodium, du molybdène, du chrome ou du cuivre et correspond à au moins l'un parmi les ligands organiques de formule IV.

9. Procédé selon l'une des revendications 1 à 3, dans lequel le complexe métallique comprend du bismuth, de l'étain, du zinc, du rhodium, du molybdène, du chrome ou du cuivre et correspond à au moins l'un parmi les ligands organiques de formule V.

10. Procédé selon l'une des revendications précédentes,
dans lequel les radicaux R² et R³, R², R³ et R⁴ ou G sont dans chaque cas au moins monofluorés.

11. Procédé selon l'une des revendications précédentes,
dans lequel R_{F} ou R_{V} comprend les radicaux Q1a à Q29 ou est constitué des radicaux Q1a à Q29 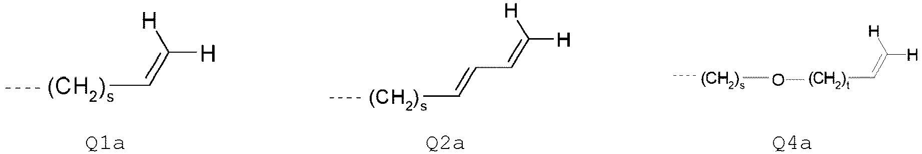 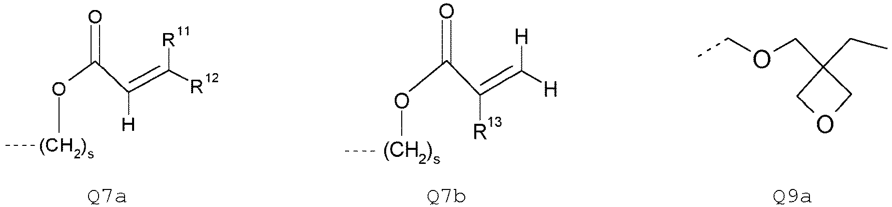 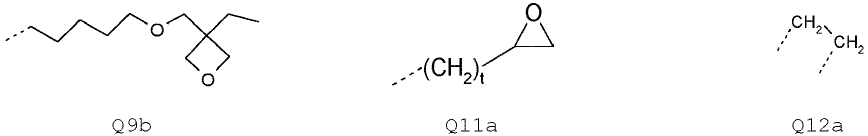 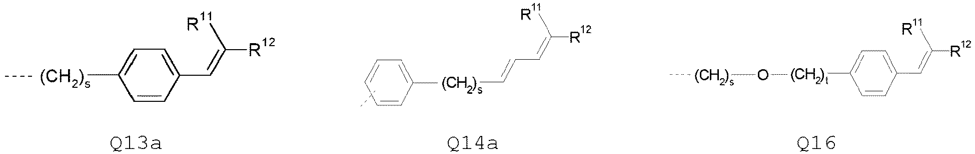 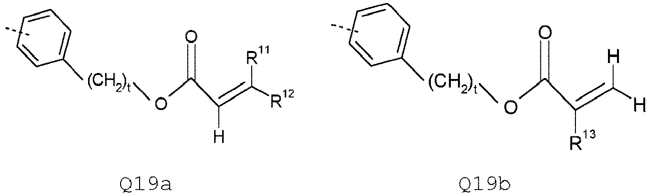 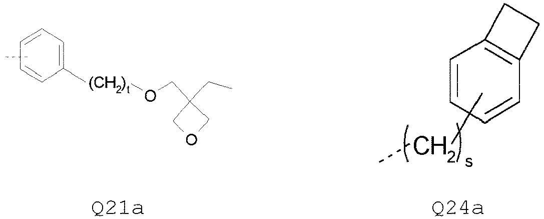 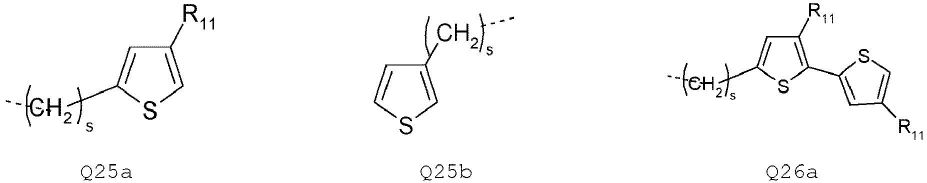 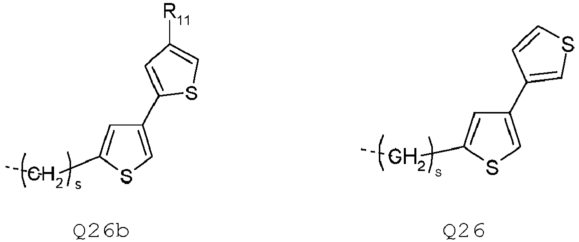 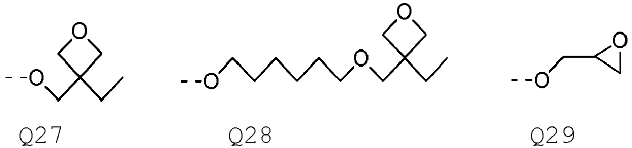 où les radicaux
R¹¹ et R¹² peuvent être identiques ou différents et sont choisis dans le groupe comprenant H, D ou un groupement C1-C6 alkyle à chaîne linéaire ou ramifiée,
R¹³ est un groupement C1-C6 alkyle à chaîne linéaire ou ramifiée,
s = 0 à 8 et
t = 1 à 8.

12. Procédé selon l'une des revendications précédentes,
dans lequel R_{F} ou Rv comprend les radicaux Q1b à Q26g ou est constitué des radicaux Q1b à Q26g

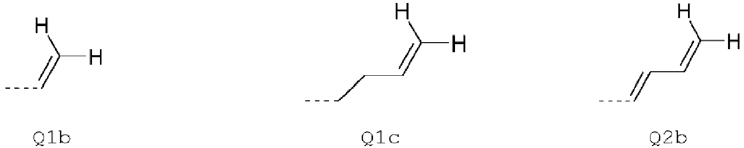

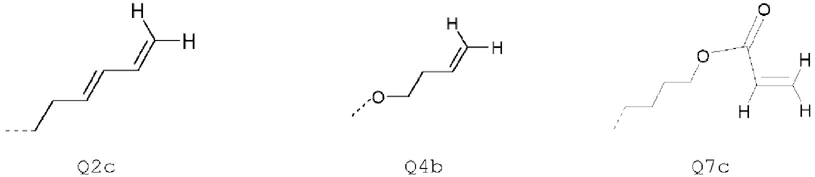

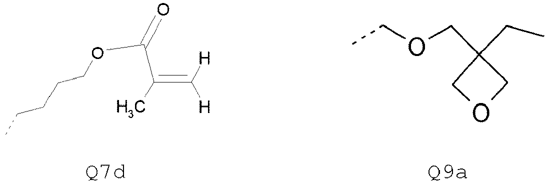

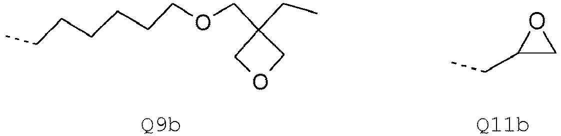

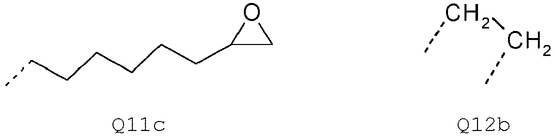

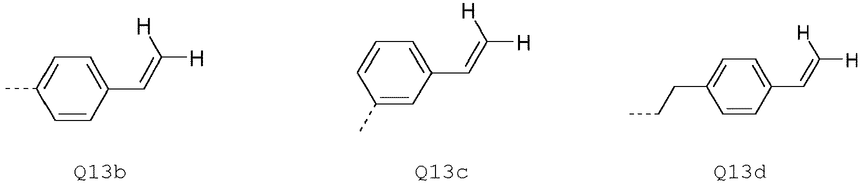

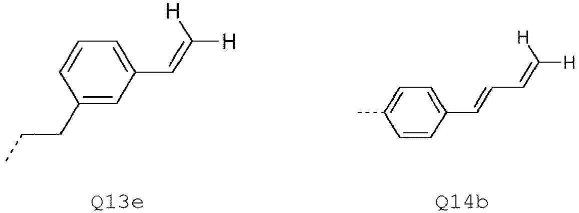

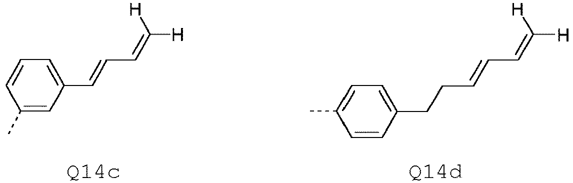

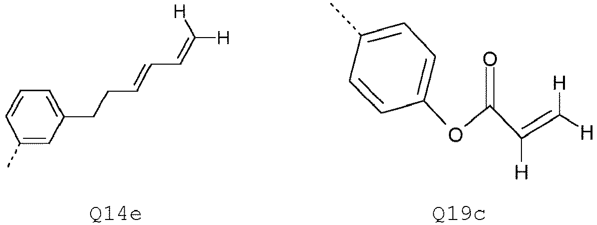

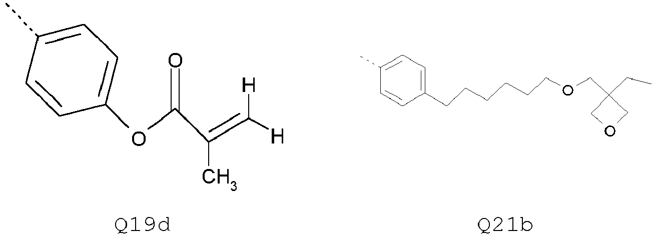

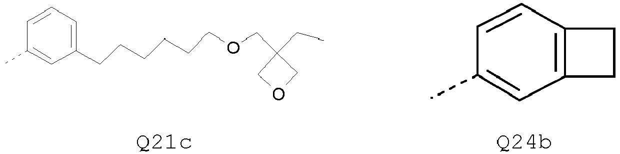

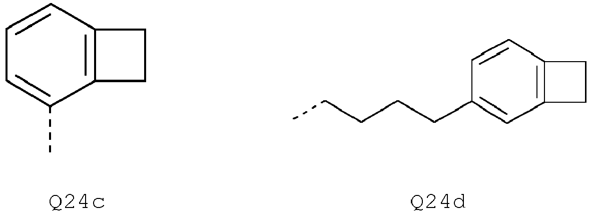

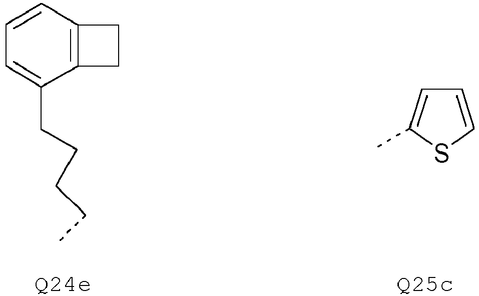

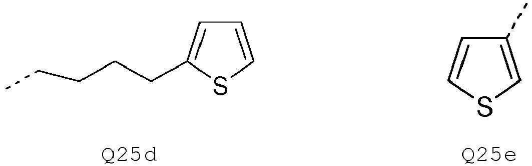

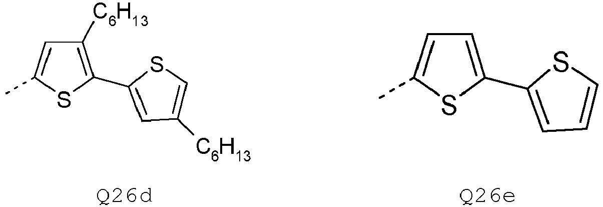

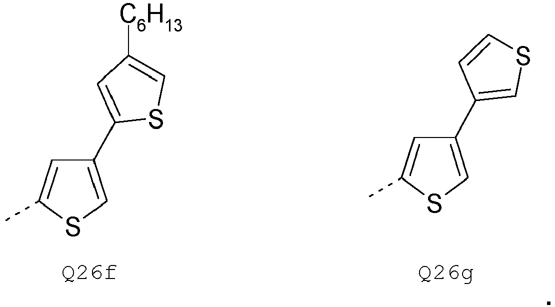

13. Procédé selon l'une des revendications précédentes,
dans lequel un bras de liaison supplémentaire est disposé entre le au moins un ligand organique et R_{F} ou le transporteur de trous et R_{F}, où le bras de liaison est choisi dans le groupe comprenant C1-C20 alkyle, alcényle, alcynyle, polyéthylène glycol, polyéthylènediamine, polyester, polyuréthane, polyvinylidènephénylène fluoré ou non fluoré ou des mélanges de ceux-ci.

14. Procédé selon la revendication 13,
dans lequel le motif comprenant le radical fonctionnalisant R_{F} et le bras de liaison, en particulier Rv, est choisi dans le groupe comprenant Q13 - Q26 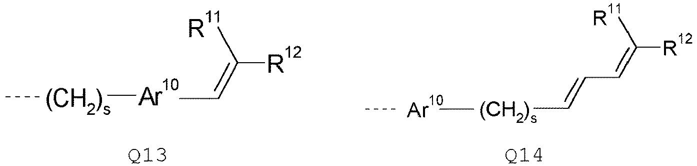 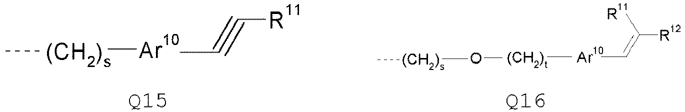 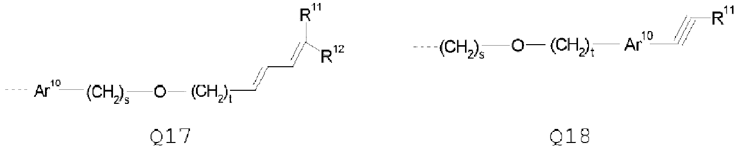 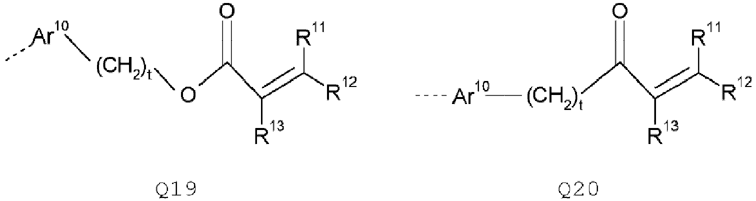 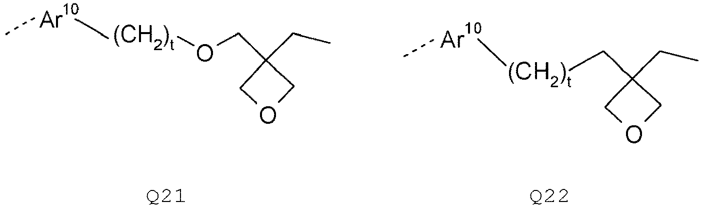 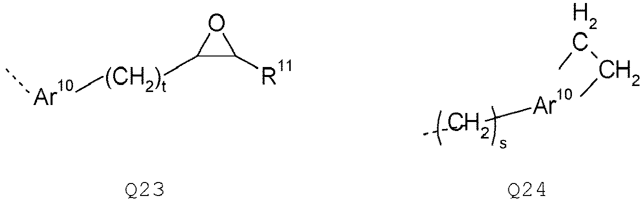 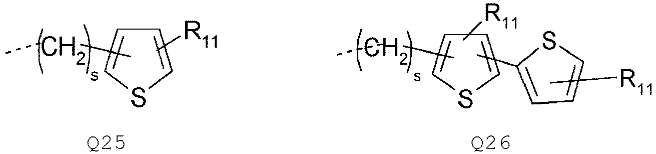
dans lesquels Ar¹⁰ est un noyau mono- ou polycyclique, aromatique ou hétéroaromatique en C5-C60, où les radicaux
R¹¹ et R¹² peuvent être identiques ou différents et sont choisis dans le groupe comprenant H, D ou un groupement C1-C6 alkyle à chaîne linéaire ou ramifiée,
R¹³ est un groupement C1-C6 alkyle à chaîne linéaire ou ramifiée,
s = 0 à 8 et
t = 1 à 8.

15. Couche électrique réticulée de transport de trous, pouvant être obtenue par un procédé selon l'une des revendications 1-14.

16. Composant électronique organique, possédant une couche électrique réticulée de transport de trous selon la revendication 15.
